# EUROPEAN PATENT SPECIFICATION

(11) **EP 1 453 675 B1**
(45) Date of publication and mention of the grant of the patent: **07.10.2009**
(21) Application number: 02786990.8
(22) Date of filing: 10.12.2002
(51) Int. Cl.: B41C 1/10, B41M 5/36, G03F 7/021, G03F 7/023, G03F 7/032, G03F 7/033, G03F 7/035

(54) **PHOTOSENSITIVE COMPOSITION AND PHOTOSENSITIVE PLANOGRAPHIC PRINTING PLATE**
LICHTEMPFINDLICHE ZUSAMMENSETZUNG UND LICHTEMPFINDLICHE FLACHDRUCKPLATTE
COMPOSITION PHOTOSENSIBLE ET CLICHE PLANOGRAPHIQUE PHOTOSENSIBLE

(30) Priority: 13.12.2001 JP 2001380582
(43) Date of publication of application: 08.09.2004
(73) Proprietor: Eastman Kodak Company, Rochester, NY 14650-2201 (US)
(72) Inventor: ISHIZUKA, Yasuhiro, 202 Akatsuchi Bldg., Tatebayashi-shi, Gunma-ken (JP); KOJIMA, Yasuhiko, Konosu-shi, Saitama-ken (JP); ASAWA, Yasuhiro, G-201 Corpo Kaneko, Gyoda-shi, Saitama-ken (JP)
(74) Representative: Vossius & Partner
(86) International application number: PCT/US2002/039410
(87) International publication number: WO 2003/051631

(56) References cited:
- EP-A- 0 737 896
- US-A- 5 272 218
- US-A- 5 700 621
- PATENT ABSTRACTS OF JAPAN vol. 2000, no. 14, 5 March 2001 (2001-03-05) & JP 2000 330265 A (FUJI PHOTO FILM CO LTD), 30 November 2000 (2000-11-30) cited in the application
- PATENT ABSTRACTS OF JAPAN vol. 008, no. 033 (P-254), 14 February 1984 (1984-02-14) & JP 58 189627 A (NIPPON GOSEI GOMU KK), 5 November 1983 (1983-11-05)

## Description

### Field of the Invention

The invention relates to a photosensitive composition that can be applied to photosensitive planographic printing plates and photoresists. More particularly, the invention relates to a photosensitive composition that gives a coating film having excellent solvent resistance and excellent wear resistance, and to a photosensitive planographic printing plate having excellent solvent resistance and excellent press-life using the same.

### Background of the Invention

A planographic printing plate used in the field of offset printing has hitherto been produced by bringing a silver salt mask film having an image previously formed thereon into close contact with a photosensitive planographic printing plate comprising a substrate, and a photosensitive layer provided on the substrate and exposing the entire surface to active light rays, thereby to transfer the image onto the photosensitive planographic printing plate, followed by wet development, post-treatment, and drying processes. Examples of a light source of active light rays used in these processes include a mercury lamp, a metal halide lamp, a xenon lamp, a chemical lamp, and a carbon arc lamp. The photosensitive layer of the photosensitive planographic printing plate is designed to be sensitive to light having a wavelength in a range of from 300 to 450 nm corresponding to an output wavelength of these light sources.

Such a photosensitive planographic printing plate includes, for example, a positive-working photosensitive planographic printing plate, which can be developed with a developer of an aqueous alkali solution (hereinafter referred to as an alkali developer). As a positive-working photosensitive composition used in a photosensitive layer of such a positive-working photosensitive planographic printing plate, a photosensitive composition containing an alkali-soluble resin, such as a novolac resin, and a quinone diazide compound is known.

In addition, a negative-working photosensitive planographic printing plate, which can be developed with an aqueous alkali developer, is also known. Examples of the negative-working photosensitive composition used in the photosensitive layer of the negative-working photosensitive planographic printing plate include a photosensitive composition containing an alkali-soluble resin and a photosensitive diazonium compound, and a photosensitive composition containing an alkali-soluble resin, an ethylenically unsaturated compound, and a radical polymerization initiator.

With the progress of computer image processing techniques, a method of directly writing an image by irradiation with light corresponding to a digital signal has recently been developed. Intense interest has been shown towards a computer-to-plate (CTP) system of directly forming an image on a photosensitive planographic printing plate without outputting to a silver salt mask film, by utilizing this system in a planographic printing plate. As a light source for irradiation with light, a laser having a maximum intensity in the ultraviolet, visible or infrared range of from 300 nm to 1200 nm, such as an Ar ion laser, YAG laser, He-Ne laser, or semiconductor laser, can be used. The CTP system using a high-output laser having a maximum intensity within a near infrared or infrared range as a light source for irradiation with light has such advantages that a high-resolution image can be obtained by exposure in a short time and a photosensitive planographic printing plate used in the system can be handled in a lighted room. Particularly, high-output and small-sized lasers are easily available as a solid laser and a semiconductor laser, which emit infrared rays having a wavelength in a range of from 760 to 1200 nm.

As the positive-working photosensitive composition that can form an image using the solid laser or semiconductor laser capable of emitting infrared light, a photosensitive composition comprising an alkali-soluble resin (for example, a novolac resin) and a photothermal conversion material (for example, an infrared absorber such as a dye or pigment) is known.

As the negative-working photosensitive composition that can form an image using the solid laser or semiconductor laser capable of emitting infrared light, a photosensitive composition comprising an alkali-soluble resin (for example, novolac resin), an acid crosslinking agent (for example, resol resin), a compound capable of generating an acid by means of heat (for example, an acid generating agent), and a photothermal conversion material (for example, an infrared absorber such as a dye or pigment) is proposed in Japanese Unexamined Patent Application, First Publication No. Hei 7-20629.

As the negative-working photosensitive composition that can form an image using a laser which emits infrared light from visible light, such as an Ar ion laser, YAG laser, He-Ne laser, or semiconductor laser, those comprising an ethylenically unsaturated compound, a sensitizing pigment having an absorption maximum in a range of from 400 to 1200 nm, and a photopolymerization initiator are proposed in Japanese Unexamined Patent Application, First Publication No. 2000-181059, and Japanese Unexamined Patent Application, First Publication No. Hei 2-244050.

Examples of the alkali-soluble resin used in the photosensitive layer of the alkali-developable photosensitive planographic printing plate include, for example, vinyl polymers having an acid group such as a carboxyl group, a phenolic hydroxyl group, a sulfonic acid group, a phosphoric acid group, a sulfonamide group, or an active imide group; polyaddition polymers such as polyurethanes; and polycondensation polymers such as polyesters, in addition to novolac resins. However, the photosensitive layer having an alkali-soluble resin had problems such as poor solvent resistance to the solvent contained in various printing chemicals (for example, washing oil, fountain solution, gum solution, plate preserver, and plate cleaner). Particularly, it had a problem such that the resistance to the UV ink-washing oil used in UV ink printing was insufficient and the image portion became corroded with the organic solvent. As a result, it also had a problem such that the photosensitive layer was insufficient in terms of press-life.

As the photosensitive composition having improved solvent resistance, photosensitive compositions containing an alkali-soluble resin having a urea bond in the side chain are proposed in Japanese Unexamined Patent Application, First Publication No. Hei 8-339082 and Japanese Unexamined Patent Application, First Publication No. 2000-330265.

However, because the urea bond itself does not act as the alkali-soluble group, the alkali-soluble resin having a urea bond in the side chain must have an acid group such as a carboxyl group, a phenolic hydroxyl group, a sulfonic acid group, a phosphoric acid group, a sulfonamide group, or an active imide group. Therefore, the photosensitive layer made of the photosensitive composition containing the alkali-soluble resin is still insufficient in terms of solvent resistance, and an improvement in resistance to the UV ink-washing oil used in UV ink printing had been required.

Thus, an object of the present invention is to provide a photosensitive composition that can give a coating film having excellent solvent resistance and excellent wear resistance, and a photosensitive planographic printing plate having excellent solvent resistance, particularly resistance to a UV ink-washing oil used in UV ink printing, and excellent press-life.

### Summary of the Invention

To achieve the object described above, the present inventors have made intensive studies and found that a resin having a barbituric acid group in the side chain has the effect of improving the solvent resistance and wear resistance of the coating film, and thus the present invention has been completed.

The photosensitive composition of the present invention is characterized in that it contains a resin having a barbituric acid group in the side chain.

In addition, the barbituric acid group is preferably an alkali-soluble group.

The resin having a barbituric acid group in the side chain is preferably selected from the group consisting of vinyl polymers, novolac resins, polyurethanes, polyesters, and polyureas.

In addition, the photosensitive composition of the present invention is a positive-working photosensitive composition that comprises a resin containing a barbituric acid group in the side chain, and an o-quinone diazide compound.

In addition, the photosensitive composition of the present invention is a negative-working photosensitive composition that comprises a resin containing a barbituric acid group in the side chain, and a photosensitive diazonium compound.

The photosensitive composition of the present invention is a negative-working photosensitive composition that comprises a resin containing a barbituric acid group in the side chain, an ethylenically unsaturated compound, and a radical polymerization initiator.

In addition, the photosensitive composition of the present invention is a positive-working photosensitive composition that comprises a resin containing a barbituric acid group in the side chain, and a photothermal conversion material.

The photosensitive composition of the present invention is a negative-working photosensitive composition which comprises a resin containing a barbituric acid group in the side chain, a compound that generates an acid by heat, an acid crosslinking agent, and a photothermal conversion material.

In addition, the photosensitive planographic printing plate of the present invention is characterized by comprising a support and a photosensitive layer made of the photosensitive composition according to the present invention provided on the surface of the support.

### Detailed Description of the Invention

The present invention will be described in detail below.

### Resin having a barbituric acid group in the side chain

The resin having a barbituric acid group in the side chain of the present invention is not specifically limited and may be any one as long as it is a resin having a barbituric acid group represented by general formula (I), shown below, in the side chain. Among these resins, an alkali-soluble resin is preferred because the resulting planographic printing plate can be developed with an alkali developer. 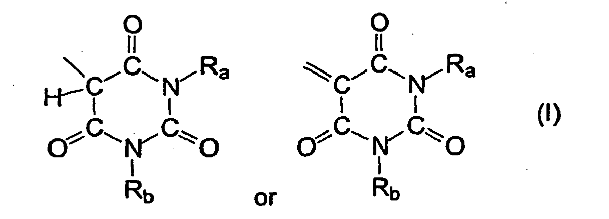 wherein Rₐ and R_{b} each independently represents a hydrogen atom, an alkyl group that may have a substituent, or a phenyl group that may have a substituent. Particularly, at least one of Rₐ and R_{b} is preferably a hydrogen atom, and such a barbituric acid group exhibits alkali solubility (or alkali affinity).

If Rₐ and R_{b} do not represent a hydrogen atom, the resin having a barbituric acid group in the side chain becomes alkali-insoluble, but can be converted into an alkali-soluble resin by introducing an acid group into the resin.

Examples of the resin having a barbituric acid group in the side chain include (i) a vinyl polymer having a barbituric acid group in the side chain, (ii) a novolac resin having a barbituric acid group in the side chain, (iii) a polyurethane having a barbituric acid group in the side chain, (iv) a polyester having a barbituric acid group in the side chain, and (v) a polyurea having a barbituric acid group in the side chain.

Examples of the vinyl polymer having a barbituric acid group in the side chain (i) include a vinyl polymer having a constituent unit represented by the general formula (II) shown below. 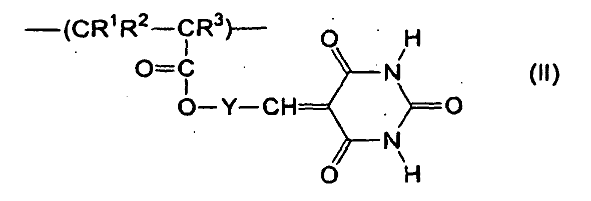 wherein R¹ and R² each independently represent a hydrogen atom, a halogen atom, an alkyl group, an aryl group, or a carboxyl group or a salt thereof, R³ represents a hydrogen atom, a halogen atom, an alkyl group, or an aryl group, and Y represents a divalent linking group. Y is, for example, an alkylene group that may have a substituent, or a phenylene group that may have a substituent.

The vinyl polymer having a constituent unit represented by the general formula (II) can be obtained, for example, by a method comprising the steps of reacting a vinyl monomer having an aldehyde group (a) with barbituric acid (b), as shown in the reaction scheme (III) below, thereby to synthesize a vinyl monomer having a barbituric acid group (c), and copolymerizing the vinyl monomer (c) with the other vinyl monomer (method A by the copolymerization reaction); or a method comprising the steps of copolymerizing a .vinyl monomer having an aldehyde group (a) with the other vinyl monomer to obtain a vinyl polymer having an aldehyde group, and reacting the vinyl polymer with barbituric acid (b) (method B by the modification reaction).

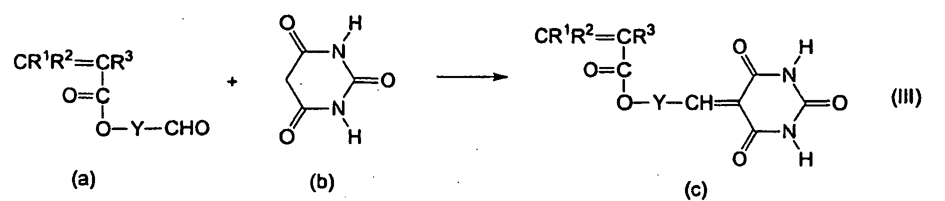

The vinyl monomer having an aldehyde group (a) can be employed in the present invention as long as it is a compound having a vinyl polymerizable unsaturated bond and an aldehyde group, and examples thereof include condensates of hydroxybenzaldehydes and (meth)acrylic acid chloride, adducts of hydroxybenzaldehydes and methacryloyloxyethyl isocyanate, and adducts of glycidyl (meth)acrylate and carboxybenzaldehydes.

Examples of the hydroxybenzaldehydes include 2-hydroxybenzaldehyde, 3-hydroxybenzaldehyde, 4-hydroxybenzaldehyde, 3-methoxy-2-hydroxybenzaldehyde, 4-methoxy-3-hydroxybenzaldehyde, 3-methoxy-4-hydroxybenzaldehyde, 5-chloro-2-hydroxybenzaldehyde, and 3,5-di-tert-butyl-4-hydroxybenzaldehyde. Particularly, 4-hydroxybenzaldehyde is preferably used in the present invention.

The vinyl polymer having a constituent unit represented by the general formula (II) is an example that can be employed in the present invention. Other examples of the vinyl polymer having a barbituric acid group in the side chain (i) include a vinyl polymer having a barbituric acid group in the side chain, other than that of the general formula (II), wherein acrolein or methacrolein is used as a vinyl monomer having an aldehyde group in place of the vinyl monomer having an aldehyde group (a) in the reaction scheme (III).

In addition, examples of the vinyl polymer having a barbituric acid group in the side chain include a vinyl polymer having a constituent unit represented by the general formula (IV) shown below. 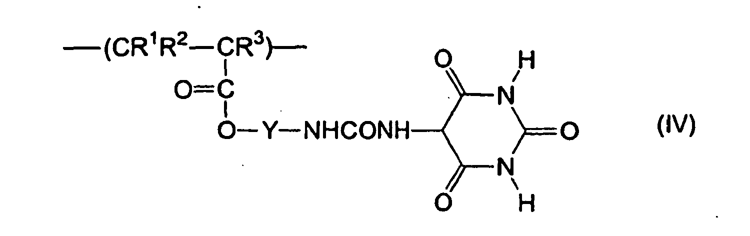 wherein R¹ and R² each independently represent a hydrogen atom, a halogen atom, an alkyl group, an aryl group, or a carboxyl group or a salt thereof, R³ represents a hydrogen atom, a halogen atom, an alkyl group, or an aryl group, and Y represents a divalent linking group. Y is, for example, an alkylene group that may have a substituent, or a phenylene group that may have a substituent.

The vinyl polymer having a constituent unit represented by the general formula (IV) shown above can be obtained, for example, by a method comprising the steps of reacting a vinyl monomer having an isocyanate group (d) with 5-aminobarbituric acid (e), as shown in the reaction scheme (V) below, thereby to synthesize a vinyl monomer having a barbituric acid group (f) and copolymerizing the vinyl monomer (f) with the other vinyl monomer (method A by the copolymerization reaction); or a method comprising the step of reacting a vinyl polymer having an isocyanate group with 5-aminobarbituric acid (e) (method B by the modification reaction).

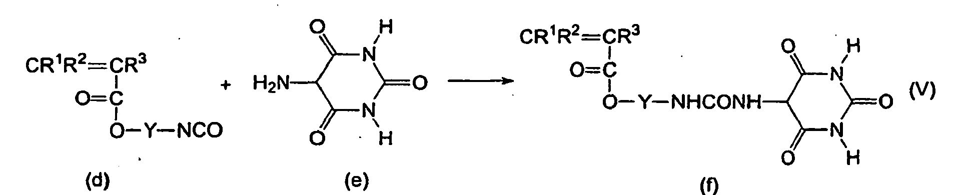

Specific examples of the other vinyl monomer include acrylic esters such as methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, and tetrahydrofurfuryl acrylate; aryl acrylates such as phenyl acrylate and furfuryl acrylate; methacrylic esters such as methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, and tetrahydrofurfuryl methacrylate; and aryl methacrylates such as phenyl methacrylate, cresyl methacrylate, and naphthyl methacrylate. Specific examples of the acrylamide or derivatives thereof include N-alkylacrylamides such as N-methylacrylamide, N-ethylacrylamide, N-propylacrylamide, N-butylacrylamide, N-t-butylacrylamide, N-heptylacrylamide, N-octylacrylamide, N-cyclohexylacrylamide, and N-benzylacrylamide; N-arylacrylamides such as N-phenylacrylamide, N-tolylacrylamide, N-nitrophenylacrylamide, N-naphthylacrylamide, and N-hydroxyphenylacrylamide; N,N-dialkylacrylamides such as N,N-dimethylacrylamide, N,N-diethylacrylamide, N,N-dibutylacrylamide, N,N-diisobutylacrylamide, N,N-diethylhexylacrylamide, and N,N-dicyclohexylacrylamide; and N,N-arylacrylamides such as N-methyl-N-phenylacrylamide, N-hydroxyethyl-N-methylacrylamide, and N-2-actamideethyl-N-acetylacrylamide. Specific examples of the methacrylamide or derivatives thereof include N-alkylmethacrylamides such as N-methylmethacrylamide, N-ethylmethacrylamide, N-propylmethacrylamide, N-butylmethacrylamide, N-t-butylmethacrylamide, N-ethylhexylmethacrylamide, N-hydroxyethylmethacrylamide, and N-cyclohexylmethacrylamide; N-arylmethacrylamides such as N-phenylmethacrylamide and N-naphthylmethacrylamide; N,N-dialkylmethacrylamides such as N,N-diethylmethacrylamide, N,N-dipropylmethacrylamide, and N,N-dibutylmethacrylamide; N,N-diarylmethacrylamides such as N,N-diphenylmethacrylamide; methacrylamide derivatives such as N-hydroxyethyl-N-methylmethacrylamide, N-methyl-N-phenylmethacrylamide, and N-ethyl-N-phenylmethacrylamide; allyl compounds such as allyl acetate, allyl caproate, allyl caprinate, allyl laurate, allyl palmitate, allyl stearate, allyl benzoate, allyl acetoacetate, allyl lactate, and allyl oxyethanol; vinyl ethers such as hexyl vinyl ether, octyl vinyl ether, dodecyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, tetrahydrofurfuryl vinyl ether, vinyl phenyl ether, vinyl tolyl ether, vinyl chlorophenyl ether, vinyl-2,4-dichlorophenyl ether, vinyl naphthyl ether, and vinyl anthranyl ether; vinyl esters such as vinyl butyrate, vinyl isobutyrate, vinyl trimethylacetaie, vinyl diethylacetate, vinyl valerate, vinyl caproate, vinyl chloroacetate, vinyl methoxyacetate, vinyl butoxyacetate, vinylphenyl acetate, vinyl acetoacetate, vinyl lactate, vinyl-beta-phenyl butyrate, vinyl cyclohexylcarboxylate, vinyl benzoate, vinyl salicylate, vinyl chlorobenzoate, vinyl tetrachlorobenzoate, and vinyl naphthoate; styrenes such as styrene, methylstyrene, dimethylstyrene, trimethylstyrene, ethylstyrene, diethylstyrene, isopropylstyrene, butylstyrene, hexylstyrene, cyclohexylstyrene, dodecylstyrene, benzylstyrene, chloromethylstyrene, trifluoromethylstyrene, ethoxymethylstyrene, acetoxymethylstyrene, methoxystyrene, 4-methoxy-3-methylstyrene, dimethoxystyrene, chlorostyrene, dichlorostyrene, trichlorostyrene, tetrachlorostyrene, pentachlorostyrene, bromostyrene, dibromostyrene, iodostyrene, fluorostyrene, 2-bromo-4-trifluoromethylstyrene, and 4-fluoro-3-trifluoromethylstyrene; crotonic esters such as butyl crotonate, hexyl crotonate, crotonic acid, and glycerol monocrotonate; dialkyl itaconates such as dimethyl itaconate, diethyl itaconate, and dibutyl itaconate; dialkyls of maleic acid and fumaric acid, such as dimethyl maleate and dibutyl fumarate; maleimides such as maleimide, N-phenyl maleimide, N-2-methylphenyl maleimide, N-2,6-diethylphenyl maleimide, N-2-chlorophenyl maleimide, N-cyclohexyl maleimide, N-lauryl maleimide, and N-hydroxyphenyl maleimide; N-vinyl pyrrolidone, N-vinyl pyridine, acrylonitrile, and methacrylonitrile.

Among these other vinyl monomers, for example, (meth)acrylic esters, (meth)acrylamides, maleimides, and (meth)acrylonitriles are preferably used.

In addition, the vinyl polymer having a constituent unit represented by the general formula (II) or (IV) shown above may have a vinyl monomer unit having an acid group such as a carboxyl group, a phenolic hydroxyl group, a sulfonic acid group, a phosphoric acid group, a sulfonamide group, or an active imide group within a range which does not impair the effects of the present invention.

The vinyl polymer having a constituent unit represented by the general formula (II) or (IV) shown above preferably contains 10 to 80% by weight of the constituent unit represented by the general formula (II) or (IV). When the proportion of the constituent unit represented by the general formula (II) or (IV) is 10% by weight or less, the solvent resistance is likely to become insufficient. On the other hand, when the proportion exceeds 80% by weight, it is likely to become impossible to dissolve in the solvent used during coating.

With respect to the molecular weight of the vinyl polymer of the constituent unit represented by the general formula (II) or (IV) shown above, preferably, the weight-average molecular weight is 2,000 or more and the number-average molecular weight is 1,000 or more. More preferably, the weight-average molecular weight is in a range of from 3,000 to 500,000, and the number-average molecular weight is in a range of from 2,000 to 400,000.

The novolac resin having a barbituric acid group in the side chain (ii) can be synthesized by linking a barbituric acid derivative having a functional group with a novolac resin via a compound having two or more functional groups capable of forming a linkage with both compounds. Examples of the barbituric acid derivative having a functional group include 5-aminobarbituric acid, and a condensate of 4-hydroxybenzaldehyde and barbituric acid. In addition, examples of the compound having two or more functional groups include a diisocyanate compound, a polyisocyanate compound, a dibasic acid chloride compound, and a diglycidyl compound. In particular, examples of the method of synthesizing the novolac resin having a barbituric acid group in the side chain (ii), which can be preferably used in the present invention, include the following.

The novolac resin having a barbituric acid group in the side chain (ii) can be obtained, for example, by a method comprising the steps of reacting 5-aminobarbituric acid (e) with a diisocyanate compound (g), as shown in the reaction scheme (VI) below, thereby to synthesize an isocyanate compound having a barbituric acid group (h), and reacting the isocyanate compound (h) with hydroxyl groups of a novolac resin. 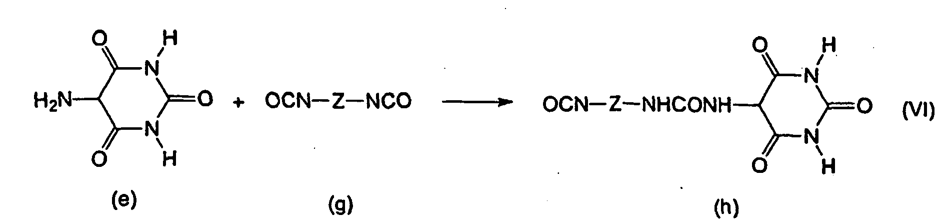 wherein Z represents a divalent linking group.

Examples of the diisocyanate compound (g) represented by OCN-Z-NCO include aromatic diisocyanate compounds such as 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyl-4,4'-diisocyanate; aliphatic diisocyanate compounds such as hexamethylene diisocyanate, trimethylhexamethylene diisocyanate, lysine diisocyanate, and dimer acid diisocyanate; alicyclic diisocyanate compounds such as isophorone diisocyanate, 4,4'-methylenebis(cyclohexyl isocyanate), methylcyclohexane-2,4 (or 2,6)-diisocyanate, and 1,3-(isocyanate methyl)cyclohexane; and diisocyanate compounds such as a reaction product of a diol and a diisocyanate, such as an adduct of 1 mol of 1,3-butylene glycol and 2 mol of tolylene diisocyanate.

As the novolac resin, a novolac resin used in the positive-working photosensitive composition (1) described hereinafter can be used.

With respect to the molecular weight of the novolac resin having a barbituric acid group in the side chain, preferably, the weight-average molecular weight is 2,000 or more, and the number-average molecular weight is 1,000 or more. More preferably, the weight-average molecular weight is in a range of from 3,000 to 500,000 and the number-average molecular weight is in a range of from 2,000 to 400,000.

The polyurethane having a barbituric acid group in the side chain (iii) includes, for example, a polyurethane wherein the barbituric acid group is introduced into the side chain by reacting a polyurethane containing an aldehyde group with barbituric acid (b).

The aldehyde group-containing polyurethane can be obtained by the polyaddition reaction between an aldehyde group-containing diol and a diisocyanate. Examples of the aldehyde group-containing diol include 2,3-dihydroxybenzaldehyde, 2,4-dihydroxybenzaldehyde, 2,5-dihydroxybenzaldehyde, 3,4-dihydroxybenzaldehyde, and 3,5-dimethylolbenzaldehyde. Examples of the diisocyanate include, for example, the same compounds as those described for the diisocyanate compound (g).

Examples of the polyester having a barbituric acid group in the side chain (iv) include a polyester wherein the barbituric acid group is introduced into the side chain by reacting the aldehyde group-containing polyester with barbituric acid (b).

The aldehyde group-containing polyester can be obtained by the polycondensation reaction between the aldehyde group-containing diol and the dibasic acid chloride. Examples of the dibasic acid chloride include phthalic acid chloride, isophthalic acid chloride, terephthalic acid chloride, tetrahydrophthalic acid chloride, hexahydrophthalic acid chloride, hexahydroterephthalic acid chloride, 2,6-naphthalenedicarboxylic acid chloride, adipic acid chloride, succinic acid chloride, sebacic acid chloride, dimer acid chloride, and maleic acid chloride.

Examples of the polyurea having a barbituric acid group in the side chain (v) include the compound shown below.

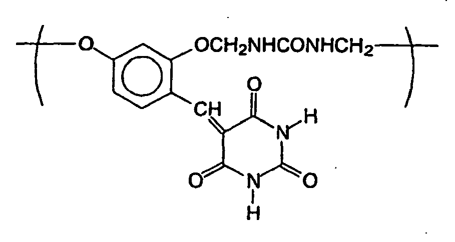

Other examples of the resin having a barbituric acid group in the side chain include those obtained by reacting a polyol (vi), such as a polyvinyl alcohol or a 2-hydroxyethyl (meth)acrylate copolymer, with an isocyanate compound having a barbituric acid group (h), and those obtained by reacting a polymer having a phenolic hydroxyl group (vii) with an isocyanate compound having a barbituric acid group (h).

Examples of the polymer having a phenolic hydroxyl group include a copolymer of a phenolic hydroxyl group-containing vinyl monomer such as CH₂=CR³-CONH-Ph-OH or CH₂=CR³-COO-Y-NHCONH-Ph-OH (wherein Ph represents a phenylene group, R³ represents a hydrogen atom, a halogen atom, an alkyl group, or an aryl group, and Y represents a divalent linking group) and another vinyl monomer.

The amount of the employed alkali-soluble resin having a barbituric acid group in the side chain is preferably in a range of from 5 to 95% by weight, and particularly preferably from 15 to 85% by weight, based on the total solid content of the photosensitive composition. When the amount of the employed alkali-soluble resin is less than 5% by weight, the developability, the solvent resistance and the wear resistance of the coating film made of the photosensitive composition are likely to become insufficient. On the other hand, when the amount exceeds 95% by weight, the developer resistance of the coating film tends to be lowered.

### Photosensitive composition

Examples of the photosensitive composition of the present invention include (1) a positive-working photosensitive composition containing an alkali-soluble resin having a barbituric acid group in the side chain and an o-quinone diazide compound; (2) a negative-working photosensitive composition containing an alkali-soluble resin having a barbituric acid group in the side chain and a photosensitive diazonium compound; (3) a negative-working photosensitive composition containing an alkali-soluble resin having a barbituric acid group in the side chain, an ethylenically unsaturated compound, and a radical polymerization initiator, (4) a positive-working photosensitive composition containing an alkali-soluble resin having a barbituric acid group in the side chain and a photothermal conversion material, for an infrared laser (for CTP); and (5) a negative-working photosensitive composition containing an alkali-soluble resin having a barbituric acid group in the side chain, a compound that generates an acid by heat, an acid crosslinking agent, and a photothermal conversion material, for an infrared laser (for CTP).

### (1) Positive-working photosensitive composition containing an o-quinone diazide compound

The o-quinone diazide compound is preferably a compound having at least one o-quinonediazide group wherein the solubility to an aqueous alkali solution increases due to active light rays. For these compounds, compounds having various structures are known and are described in detail on pages 336 to 352 of Light-Sensitive Systems (John Wiley & Sons, Inc., published in 1965), edited by J. KOSAR.

As the o-quinone diazide compound, sulfonic esters of various hydroxyl compounds and o-benzoquinonediazide or o-naphthoquinonediazide are particularly preferred.

Examples of the o-quinone diazide compound described above include esters of 1,2-naphthoquinone-2-diazide-5-sulfonyl chloride and a phenol-formaldehyde resin or a cresol-formaldehyde resin; esters of 1,2-naphthoquinone-2-diazide-5-sulfonyl chloride and a pyrogallol-acetone resin, described in U.S. Patent No. 3,635,709; esters of 1,2-naphthoquinone-2-diazide-5-sulfonyl chloride and a resorcinol-benzaldehyde resin, described in Japanese Examined Patent Application, Second Publication No. Sho 63-13528; esters of 1,2-naphthoquinone-2-diazide-5-sulfonyl chloride and a resorcinol-pyrogallol-acetone co-condensed resin, described in Japanese Examined Patent Application, Second Publication No. Sho 62-44257; compounds obtained by esterifying a polyester having a hydroxyl group at a terminal with 1,2-naphthoquinone-2-diazide-5-sulfonyl chloride, described in Japanese Examined Patent Application, Second Publication No. Sho 56-45127; compounds obtained by esterifying a homopolymer of N-(4-hydroxyphenyl)methacrylamide or a copolymer of another copolymerizable monomer with 1,2-naphthoquinone-2-diazide-5-sulfonyl chloride, described in Japanese Examined Patent Application, Second Publication No. Sho 50-24641; esters of 1,2-naphthoquinone-2-diazide-5-sulfonyl chloride and a bisphenol-formaldehyde resin, described in Japanese Examined Patent Application, Second Publication No. Sho 54-29922; compounds obtained by esterifying a homopolymer of p-hydroxystyrene or a copolymer of another copolymerizable monomer with 1,2-naphthoquinone-2-diazide-5-sulfonyl chloride, described in Japanese Examined Patent Application, Second Publication No. Sho 52-36043; and esters of 1,2-naphthoquinone-2-diazide-5-sulfonyl chloride and polyhydroxybenzophenone.

Other examples of the publicly known o-quinone diazide compounds include those described in Japanese Unexamined Patent Application, First Publication No. Sho 63-80254, Japanese Unexamined Patent Application, First Publication No. Sho 58-5737, Japanese Unexamined Patent Application, First Publication No. Sho 57-111530, Japanese Unexamined Patent Application, First Publication No. Sho 57-111531, Japanese Unexamined Patent Application, First Publication No. Sho 57-114138, Japanese Unexamined Patent Application, First Publication No. Sho 57-142635, Japanese Unexamined Patent Application, First Publication No. Sho 51-36129, Japanese Examined Patent Application, Second Publication No. Sho 62-3411, Japanese Examined Patent Application, Second Publication No. Sho 62-51459, Japanese Unexamined Patent Application, Second Publication No. Sho 51-483, Japanese Unexamined Patent Application, First Publication No. Hei 10-198030, Japanese Unexamined Patent Application, First Publication No. Hei 11-143066, Japanese Unexamined Patent Application, First Publication No. Hei 11-242325, and Japanese Unexamined Patent Application, First Publication No. Hei 11-305429.

The content of the o-quinone diazide compound is preferably in a range of from 5 to 60% by weight, and more preferably from 10 to 40% by weight, based on the total solid content of the photosensitive composition.

The positive-working photosensitive composition can contain a publicly known alkali-soluble resin, in addition to the alkali-soluble resin having a barbituric acid group in the side chain. Examples thereof include novolac resins or resol resins such as a phenol-formaldehyde resin, a m-cresol-formaldehyde resin, a p-cresol-formaldehyde resin, a m-/p-mixed cresol-formaldehyde resin, a phenol/cresol (any one of m-, p-, or m-/p-mixed) mixed formaldehyde resin, a phenol-formaldehyde resin, or a resorcinol-formaldehyde resin; polyhydroxystyrenes; acrylic resins described in Japanese Unexamined Patent Application, First Publication No. Hei 1-35558, Japanese Unexamined Patent Application, First Publication No. Hei 2-866, Japanese Unexamined Patent Application, First Publication No. Hei 8-339080, and Japanese Unexamined Patent Application, First Publication No. Hei 8-339082; and urethane resins described in Japanese Unexamined Patent Application, First Publication No. Sho 63-124047. The photosensitive composition of the present invention has a feature such that development latitude is further widened by using these publicly known resins in combination, and a novolac resin is used particularly preferably in combination with a quinonediazide compound. Preferably, the number-average molecular weight of the alkali-soluble resin is about 200 to 20,000 and the weight-average molecular weight is about 300 to 60,000.

In addition, in the positive-working photosensitive composition, cyclic acid anhydrides to enhance the sensitivity, printout agents to obtain visible images immediately after exposure, dyes as image coloring agents, and other fillers can be added, if necessary.

Examples of the cyclic acid anhydride include succinic anhydride, glutaric anhydride, itaconic anhydride, phthalic anhydride, tetrahydrophthalic anhydride, hexahydrophthalic anhydride, maleic anhydride, chloromaleic anhydride, and pyromellitic anhydride. These cyclic acid anhydrides can be added in an amount ranging from 1 to 15% by weight based on the entire composition.

Examples of the printout agent to obtain visible images immediately after exposure include a combination of a photosensitive compound capable of generating an acid by exposure and an organic dye capable of forming a salt with an acid to change color tone.

Examples of the photosensitive compound capable of generating an acid by exposure include o-naphthoquinonediazide-4-sulfonic acid halogenide described in Japanese Unexamined Patent Application, First Publication No. Sho 50-36209; trihalomethyl-2-pyrones or trihalomethyl-s-triazines described in Japanese Unexamined Patent Application, First Publication No. Sho 53-36223; various o-naphthoquinodiazide compounds described in Japanese Unexamined Patent Application, First Publication No. Sho 55-62444; 2-trihalomethyl-5-aryl-1,3,4-oxadiazole compounds described in Japanese Unexamined Patent Application, First Publication No. Sho 55-77742; and diazonium salts. These compounds can be used alone or in combination, and the amount is preferably in a range of from 0.3 to 15% by weight based on the total weight of the composition.

Examples of the organic dye capable of forming a salt include a triphenylmethane dye, a cyanine dye, a diazo dye, and a styryl dye, and specific examples thereof include Crystal Violet, Ethyl Violet, Methyl Violet, Methylene Blue, Victoria Blue BH, Victoria Pure Blue BOH, Malachite Green, Oil Blue #603, Oil Green BG, Brilliant Green, fuchsin, eosin, Rhodamine B, Oil Pink #312, Oil Red 5B, Oil Black BS, Oil Yellow #101, phenolphthalein, Cresol Red, auramine, Leucocrystal Violet, and Leucomalachite Green. The amount thereof is preferably in a range of from 0.3 to 15% by weight based on the total weight of the composition.

In the positive-working photosensitive compositions, various additives can be added depending on the purpose, for example, various resins having a hydrophobic group to improve the inking properties of the image, such as an octylphenol-formaldehyde resin, a t-butylphenol-formaldehyde resin, a t-butylphenol-benzaldehyde resin, a rosin-modified novolac resin, and o-naphthoquinonediazide sulfonate esters of these modified novolac resin; and plasticizers to improve the pliability of the coating film, such as butyl phthalate, dioctyl phthalate, butyl glycolate, tricresyl phosphate, and dioctyl adipate. The amount thereof is preferably in a range of from 0.01 to 30% by weight based on the total weight of the composition.

### (2) Negative-working photosensitive composition containing a photosensitive diazonium compound

Examples of the photosensitive diazonium compound include, for example, a diazo resin represented by a salt of a condensate of a diazodiarylamine and an active carbonyl compound.

Examples of the particularly preferred diazo resins include organic acid salts or inorganic acid salts of condensates of 4-diazodiphenylamine, 4-diazo-3-methyl-diphenylamine, 4-diazo-4'-methyldiphenylamine, 4-diazo-3'-methyldiphenylamine, 4-diazo-4'-methoxydiphenylamine, 4-diazo-3-methyl-4'-ethoxydiphenylamine, or 4-diazo-3-methoxy-diphenylamine, and formaldehyde, paraformaldehyde, acetaldehyde, benzaldehyde, or 4,4'-bis-methoxymethyl diphenyl ether.

Examples of the organic acid of the diazo resin include methanesulfonic acid, benzenesulfonic acid, toluenesulfonic acid, xylenesulfonic acid, mesitylenesulfonic acid, dodecylbenzenesulfonic acid, naphthalenesulfonic acid, propylnaphthalenesulfonic acid, 1-naphthol-5-sulfonic acid, 2-nitrobenzenesulfonic acid, 3-chlorobenzenesulfonic acid, and 2-hydroxy-4-methoxybenzophenone-5-sulfonic acid, and examples of the inorganic acid include hexafluorophosphoric acid, tetrafluoroboric acid, and thiocyanic acid.

Furthermore, a diazo resin wherein a principal chain is a polyester group, described in Japanese Unexamined Patent Application, First Publication No. Sho 54-30121; a diazo resin obtained by reacting a polymer having a carboxylic anhydride residue with a diazo compound having a hydroxyl group, described in Japanese Unexamined Patent Application, First Publication No. Sho 61-273538; and a diazo resin obtained by reacting a polyisocyanate compound with a diazo compound having a hydroxyl group can be used.

The amount of these diazo resins is preferably in a range of from 5 to 40% by weight based on the solid content of the composition, and if necessary, two or more kinds of diazo resins may be used in combination.

In the negative-working photosensitive compositions, publicly known additives such as dyes, pigments, plasticizers, and stability modifiers can be added to improve the performances.

Examples of the preferred dye include basic oil-soluble dyes such as Crystal Violet, Malachite Green, Victoria Blue- Methylene Blue, Ethyl Violet, and Rhodamine B. Examples of the commercially available products thereof include "Victoria Pure Blue BOH" (manufactured by Hodogaya Chemical Industries, Co., Ltd.) and "Oil Blue #603" (manufactured by Orient Chemical Industries, Ltd.). Examples of the pigment include Phthalocyanine Blue, Phthalocyanine Green, Dioxadine Violet, and Quinacridon Red.

Examples of the plasticizer include diethyl phthalate, dibutyl phthalate, dioctyl phthalate, tributyl phosphate, trioctyl phosphate, tricresyl phosphate, tri(2-chloroethyl) phosphate, and tributyl citrate.

As publicly known stability modifiers, for example, phosphoric acid, phosphorous acid, oxalic acid, tartaric acid, malic acid, citric acid, dipicolinic acid, polyacrylic acid, benzenesulfonic acid, and toluenesulfonic acid can be used in combination.

The amount of these additives varies depending on the purpose, but is preferably 30% by weight or less based on the solid content of the photosensitive composition.

### (3) Negative-working photosensitive composition containing an ethylenically unsaturated compound and a radical polymerization initiator

The ethylenically unsaturated compound is a monomer or oligomer that has a boiling point under normal pressure of 100°C or higher and has at least one, preferably 2 or more, addition-polymerizable ethylenically unsaturated groups per molecule. Examples of the monomer or oligomer described above include monofunctional (meth)acrylates such as polyethylene glycol mono(meth)acrylate [hereinafter, methacrylate and acrylate are generically referred to as (meth)acrylate], polypropylene glycol mono(meth)acrylate, and phenoxyethyl (meth)acrylate; and polyfunctional (meth)acrylates such as polyethylene glycol di(meth)acrylate, polypropylene glycol di(meth)acrylate, trimethylolpropane tri(meth)acrylate, neopentyl glycol di(meth)acrylate, pentaerythritol tri(meth)acrylate, pentaerythritol tetra(meth)acrylate, dipentaerythritol hexa(meth)acrylate, hexanediol di(meth)acrylate, tri(acyloyloxyethyl) isocyanurate, (meth)acrylates of polyhydric alcohol-alkylene oxide adducts, (meth)acrylates of polyhydric phenol-alkylene oxide adducts, urethane acrylates described in Japanese Examined Patent Application, Second Publication No. Sho 48-41708, Japanese Examined Patent Application, Second Publication No. Sho 50-6034, and Japanese Examined Patent Application, Second Publication No. Sho 51-37193, polyester acrylates described in Japanese Patent Application, First Publication No. Sho 48-64183, Japanese Examined Patent Application, Second Publication No. Sho 49-43191, and Japanese Examined Patent Application, Second Publication No. Sho 52-30490, and epoxy acrylates obtained by the addition reaction between an epoxy resin and (meth)acrylic acid.

The amount of these compounds having an addition-polymerizable ethylenically unsaturated group is preferably in a range of from 5 to 70% by weight based on the solid content of the composition.

As the radical polymerization initiator, various photoinitiators known from patents and references, or combinations (photoinitiation systems) of a radical polymerization initiator and a sensitizing pigment can be appropriately selected and used according to the wavelength of the light source used. When using light having a wavelength of about 400 nm as the light source, benzyl, benzoin ether, Michler's ketone, anthraquinone, thioxanthone, acridine, phenazine, and benzophenone are widely used.

When using a laser of visible light or near infrared light having a wavelength of 400 nm more as the light source, various photoinitiation systems using the radical polymerization initiator in combination with the sensitizing pigment are proposed. The radical polymerization initiator is not specifically limited and may be any one as long as it can form active species, which are required to subject the addition-polymerizable compound component having an ethylenically unsaturated double bond in the photopolymerizable composition of the present invention to the polymerization reaction, by means of the electron transfer reaction or the energy from the sensitizing pigment which has absorbed visible light or near infrared light energy. Examples of the radical polymerization initiator used in the present invention include bisimidazole compounds such as 2,2'-bis(o-chlorophenyl)-4,4',5,5'-tetraphenyl-1,1'-biimidazole, and 2,2'-bis(o-chlorophenyl)-4,4',5,5'-tetrakis(2,3-dimethoxyphenyl)-1,1'-biimidazole; 2,4,6-substituted 1,3,5-triazine compounds such as 2,4,6-tris(trichloromethyl)-1,3,5-triazine, 2-methyl-4,6-bis(trichloromethyl)-1,3,5-triazine, 2-phenyl-4,6-bis(trichloromethyl)-1,3,5-triazine, 2,4-bis(trichloromethyl)-6-(p-methoxyphenylvinyl)-1,3,5-triazine, and 2-(4'-methoxy-1'-naphthyl)-4,6-bis(trichloromethyl)-1,3,5-triazine; onium salt compounds such as diaryliodonium salts and triarylsulfonium salts obtained by using diphenyliodonium, 4,4'-dichlorodiphenyliodonium, 4,4'-dimethoxydiphenyliodonium, 4,4'-di-t-butyldiphenyliodonium, 4-methyl-4'-isopropyl-diphenyliodonium, or 3,3'-dinitrodiphenyliodonium in combination with chloride, bromide, tetrafluoroborate, hexafluorophosphate, hexafluoroarsenate, hexafluoroantimonate, tetrakis(pentafluorophenyl) borate, or trifluoromethanesulfonic acid; metal arene complexes such as titanocene and ferrocene; benzoin ether compounds such as benzyl, benzoin, benzoin alkyl ether, and 1-hydroxycyclohexyl phenyl ketone; ketal compounds such as benzyl alkyl ketal; acetophenone compounds such as 2,2'-dialkoxyacetophenone, 2-hydroxy-2-methylpropiophenone, p-t-butyltrichloroacetophenone, and p-t-butylcycloacetophenone; benzophenone compounds such as benzophenone, 4-chlorobenzophenone, 4,4'-dichlorobenzophenone, methyl o-benzoylbenzoate, 3,3'-dimethyl-4-methoxybenzophenone, 4-benzoyl-4'-methyldiphenyl sulfide, and dibenzosuberone; thioxanthone compounds such as thioxanthone, 2-chlorothioxanthone, 2-alkylthioxanthone, and 2,4-dialkylthioxanthone; anthraquinone compounds; peroxides such as 3,3',4,4'-tetra(t-butylperoxycarbonyl)benzophenone; and N-arylglycine compounds such as N-phenylglycine, N-(p-chlorophenyl)glycine, N-hydroxyethyl-N-phenylglycine, and N-(2-hydroxy-3-methacryloxypropyl)-N-phenylglycine. In the present invention, two or more kinds of these radical polymerization initiators may be optionally used in combination.

The sensitizing pigments can absorb visible light or near infrared light. Examples of the sensitizing pigments described above include azo pigments, anthraquinone pigments, benzoquinone pigments, naphthoquinone pigments, diaryl and triarylmethane pigments, cyanine pigments, merocyanine pigments, fluoran pigments, squarylium pigments, croconium pigments, pyrylium pigments, thiopyrylium pigments, phthalocyanine derivatives, naphthalocyanine derivatives, indigo pigments, cumarin pigments, ketocumarin pigments, quinacridon pigments, quinophthalon pigments, pyrrolopyrrole pigments, benzodifuranone pigments, acridine pigments, oxazine pigments, thiazine pigments, xanthene pigments, thioxanthene pigments, styryl pigments, spiropyran pigments, spirooxazine pigments, and organic rutenium complexes. As the sensitizing pigments described above, any pigments described in already-known publications can be used such as "Functional Pigments" (1992, Kodansha Scientific), edited by Makoto OHGAWARA; "Chemistry and Application of Pigments" (1994, Dainippon Tosho), edited by Ken MATSUOKA; and "Pigment Handbook" (1986, Kodansha), edited by Makoto OHGAWARA. In the photopolymerizable compositions of the present invention, two or more kinds selected from the above sensitizing pigments or pigments can be optionally used in combination as the sensitizing pigments to absorb light having a corresponding wavelength.

The total amount of the radical polymerization initiator and the sensitizing pigment is preferably in a range of from 0.5 to 20% by weight based on the solid content of the composition.

In the negative-working photosensitive composition, publicly known additives such as dyes, pigments, plasticizers, and stability modifiers can be added to improve the performances, in the same manner as described in the above negative-working photosensitive composition (2).

The amount of these additives varies depending on the purpose, but is preferably not more than 30% by weight based on the solid content of the photosensitive composition.

The features of the negative-working photosensitive compounds (2) and (3) described above are that, when using a photosensitive diazonium compound, adhesion between a photosensitive layer and a support is good, and that, when using an ethylenically unsaturated compound in combination with a radical polymerization initiator, a tough coating film can be obtained by exposure. In addition, when using a photosensitive diazonium compound, an ethylenically unsaturated compound, and a radical polymerization initiator in combination, a coating film having the two features described above can be obtained.

Furthermore, in the negative-working photosensitive compositions, the following resins can be used as the binder resin: copolymers such as a (meth)acrylic acid-(meth)acrylate copolymer, a copolymer containing a hydroxyalkyl (meth)acrylate and (meth)acrylonitrile, having an acid value of 10 to 100, described in U.S. Patent No. 4,123,276, a copolymer having an aromatic hydroxyl group as described in Japanese Examined Patent Application, Second Publication No. Sho 57-43890, and a polymer having a 2-hydroxy-3-phenoxypropyl (meth)acrylate unit described in Japanese Examined Patent Application, Second Publication No. Sho 57-51656; epoxy resins; polyamide resins; vinyl halides, particularly polyvinyl chloride and polyvinylidene chloride; polyvinyl acetates; polyesters; acetal resins such as a formal resin and a butyral resin; soluble polyurethane resins which are commercially available from Goodrich U.S.A. under the trade name of Estan; polystyrenes; styrene-maleic anhydride copolymers or semi-esters thereof; cellulose derivatives; shellac; rosins or modified compounds thereof; and copolymers having an unsaturated group in the side chain as described in Japanese Unexamined Patent Application, First Publication No. Sho 61-285449.

### (4) Positive-working photosensitive composition containing photothermal conversion material, for an infrared laser

The photothermal conversion material is a substance which has a light absorption range in a near infrared to infrared range having a wavelength in a range of from 700 to 3000 nm, preferably 750 to 1200 nm, and absorbs light to generate heat. Examples of the substance include various pigments and dyes.

As the pigments employed in the present invention, commercially available pigments can be utilized. Examples of the pigments include black pigments, yellow pigments, orange pigments, brown pigments, red pigments, violet pigments, blue pigments, green pigments, fluorescent pigments, and other polymer bonded pigments. Specifically, insoluble azo pigments, azo lake pigments, condensed azo pigments, chelate azo pigments, phthalocyanine pigments, anthraquinone pigments, perylene and perinone pigments, thioindigo pigments, quinacridon pigments, dioxazine pigments, isoindolinone pigments, quinophthalon pigments, dyeing lake pigments, azine pigments, nitroso pigments, nitro pigments, natural pigments, fluorescent pigments, inorganic pigments, and carbon black can be used.

Among these pigments, carbon black is preferably used as a substance that absorbs light in the near infrared to infrared range to efficiently generate heat and is economically excellent.

These pigments may be used without being subjected to a surface treatment, or may be used after being subjected to a publicly known surface treatment. Examples of the method for publicly known surface treatments include a method of coating the surface with a resin or wax, a method of coating with a surfactant, and a method of depositing a reactive substance such as a silane coupling agent, an epoxy compound, or a polyisocyanate, on the surface of the pigment.

The particle size of the pigment used in the present invention is preferably in a range of from 0.01 to 15 micrometers, and more preferably from 0.01 to 5 micrometers. Grafted carbon black, wherein the dispersibility in the dispersion solvent was improved by graft polymerization, is in particular, preferably used in the photosensitive compositions of the present invention.

Examples of the dye used in the present invention include cyanine dye, squarylium dye, croconium dye, azulenium dye, phthalocyanine dye, naphthalocyanine dye, polymethine dye, naphthoquinone dye, thiopyrylium dye, dithiol metal complex dye, anthraquinone dye, indoaniline dye, and intermolecular CT dye. Specific examples of the dye include compounds described in Japanese Unexamined Patent Application, First Publication No. Sho 59-202829, Japanese Unexamined Patent Application, First Publication No. Sho 58-194595, Japanese Unexamined Patent Application, First Publication No. Sho 60-63744, Japanese Unexamined Patent Application, First Publication No. Sho 58-112792, Japanese Unexamined Patent Application, First Publication No. Sho 57-142645, Japanese Unexamined Patent Application, First Publication No. 2000-310852, Japanese Unexamined Patent Application, First Publication No. 2000-199950, and Japanese Unexamined Patent Application, First Publication No. 2000-131837.

More specifically, compounds of the structural formulae 1 to 5 shown below can be listed. Dyes used in the present invention are not limited thereto. 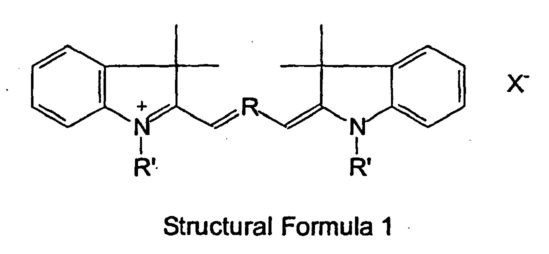 wherein R represents 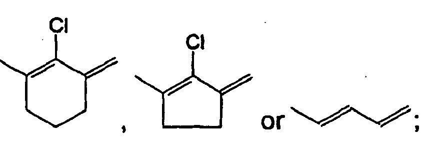 R' represents -CH₂CH₂CH₂CH₂SO₃Na/-CH₂CH₂CH₂CH₂SO₃⁻, -CH₃, -C₂H₅, -C₄H₉ or -C₃H₇; and X- represents Cl⁻, Br⁻, BF₄⁻, ClO₄⁻ or 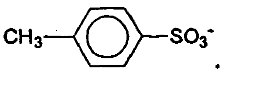 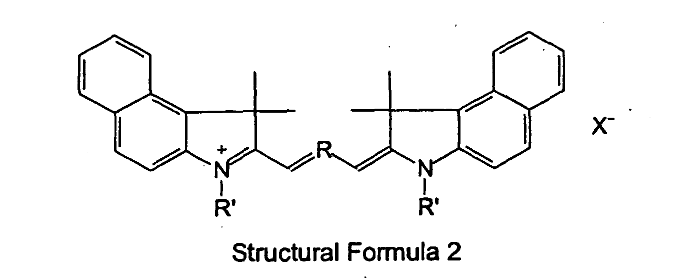 wherein R represents 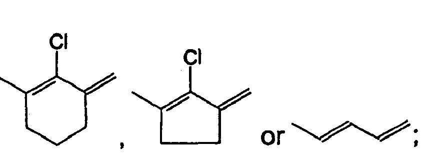 R' represents -CH₃, -C₂H₅, -C₃H₇, -C₄H₉ or -CH₂CH₂CH₂CH₂SO₃Na/-CH₂CH₂CH₂CH₂SO₃⁻; and X⁻ represents Cl⁻, Br⁻, ClO₄⁻, BF₄⁻ or 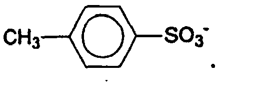 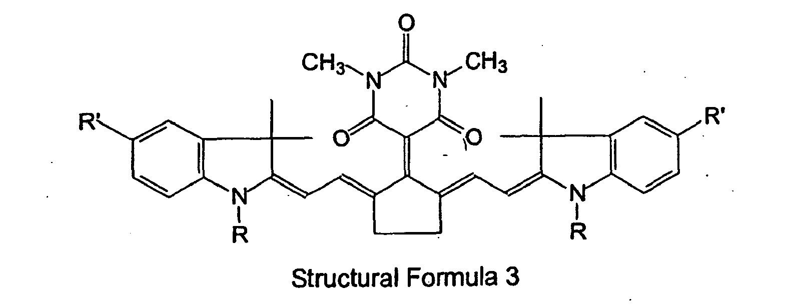 wherein R represents -CH₃, -C₂H₅, -C₃H₇, -CH₂CH₂CH₂CH₂CH₂COOH or -CH₂CH₂CH₂CH₂SO₃Na; and R' represents -H or -SO₃Na. 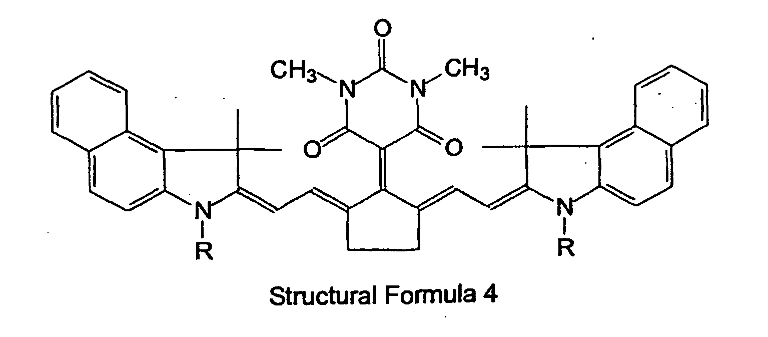 wherein R represents -CH₃, -C₂H₅, -C₃H₇, -CH₂CH₂CH₂CH₂SO₃Na or -CH₂CH₂CH₂CH₂CH₂COOH. 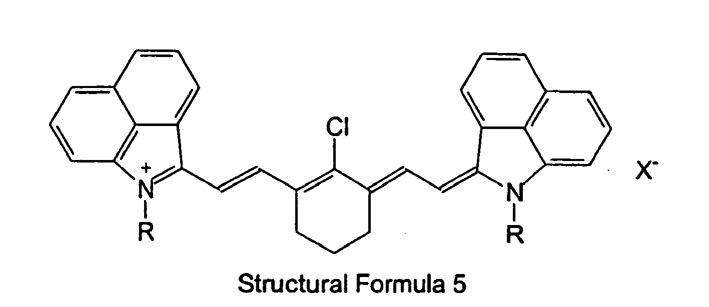 wherein R represents -C₁₂H₂₅, -C₁₀H₂₁, -C₈H₁₇, -C₂H₅, -C₃H₇ or -CH₃, and X⁻ represents Cl⁻, Br⁻, ClO₄⁻ or

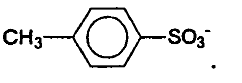

Examples of the commercially available products include IR750 (anthraquinone compounds); IR002 and IR003 (aluminum compounds); IR820 (polymethine compound); IRG022 and IRG033 (diimmonium compounds); CY-2, CY-4, CY-9, and CY-20, which are commercially available from Nippon Kayaku Kabushiki Kaisha; KIR103 and SIR103 (phthalocyanine compounds); KIR101 and SIR114 (anthraquinone compounds); PA1001, PA1005, PA1006, and SIR128 (metal complex compounds), which are commercially available from Mitsui Chemicals; Fastogen Blue 8120 which is commercially available from DAINIPPON INK & CHEMICALS Co., Ltd.; MIR-101, 1011, and 1021 manufactured by Midori Chemical Co., Ltd.; Pro-JET 825LDI, Pro-JET 830DI, S-175139/1, S-175139/2, S-175140/5, S-175140/6, S-178376/1, and S-189632/1, which are commercially available from AVECIA Company; S-0094, S-0121, S-0229, S-0253, S-0260, S-0270, S-0306, S-0322, S-0325, S-0337, S-0345, S-0378, S-0389, S-0391, S-0402, S-0447, S-0450, S-0484, S-0492, and S-0585, which are commercially available from FEW Company; and compounds which are commercially available from Nihon Kanko Shikiso Co., Ltd., Sumitomo Chemical Industries Co., Ltd., and Fuji Photo Film Co., Ltd.

As the photothermal conversion material, an appropriate pigment or dye, which can absorb light having a specific wavelength from the light source below and can convert light into heat, can be used by appropriately selecting from the above pigments or dyes.

When using the pigment or dye as the photothermal conversion material, the amount thereof is preferably in a range of from 0.01 to 50% by weight, and particularly preferably from 0.1 to 20% by weight, based on the total solid content of the positive-working photosensitive composition. When the amount of the pigment is less than 0.01% by weight, the developer resistance of the image portion is lowered. On the other hand, when the amount is more than 50% by weight, the developability of the non-image portion (exposed portion) is lowered. Therefore, they are not preferable.

These photothermal conversion materials generally substantially lower the solubility in an aqueous alkali solution of a photosensitive composition containing an alkali-soluble resin and impart resistance to the alkali developer to the non-exposed portion.

It is also possible to simultaneously use another compound having an action of substantially lowering the solubility in the aqueous alkali solution of the photosensitive composition containing an alkali-soluble resin. Examples of the compound described above include onium salts, aromatic sulfone compounds, aromatic sulfonate compounds, phosphate compounds, aromatic carboxylate compounds, aromatic disulfone compounds, aromatic ketone compounds, aromatic aldehyde compounds, aromatic ether compounds, and o-quinone diazide compounds.

In the positive-working photosensitive compositions for an infrared laser, publicly known additives, for example, cyclic acid anhydrides to enhance the sensitivity, printout agents to obtain visible images immediately after exposure, dyes as image coloring agents, various resins having a hydrophobic group to improve the inking properties of the image, plasticizers to improve the pliability of the coating film, and publicly-known resins added to improve the wear resistance of the coating film can be added.

Examples of the cyclic acid anhydride include succinic anhydride, glutaric anhydride, itaconic anhydride, phthalic anhydride, tetrahydrophthalic anhydride, hexahydrophthalic anhydride, maleic anhydride, chloromaleic anhydride, trimellitic anhydride, and pyromellitic anhydride. The amount thereof is preferably 15% by weight or less in the photosensitive composition.

The printout agent to obtain visible images immediately after exposure includes, for example, a combination of a heat-sensitive compound that generates an acid by exposure to high-density energy light, and an organic dye that forms a salt with an acid to change the color tone.

Examples of the heat-sensitive compound that generates an acid by exposure to high-density energy light include, latent Brönsted acids described in Japanese Unexamined Patent Application, First Publication No. Hei 7-20629; acid precursors described in Japanese Unexamined Patent Application, First Publication No. Hei 8-220752; compounds that can generate an acid by irradiation with active light rays as described in Japanese Unexamined Patent Application, First Publication No. Hei 9-171254; compounds that generate an acid by heat as described in Japanese Unexamined Patent-Application, First Publication No. Hei 9-211863; compounds that generate an acid by irradiation with active light rays or radial rays described in Japanese Patent Application, First Publication No. Hei 9-211864 and Japanese Unexamined Patent Application, First Publication No. Hei 9-211865; and onium borate complexes as described in Japanese Unexamined Patent Application, First Publication No. Hei 9-304931. The amount thereof is preferably not more than 15% by weight based on the photosensitive composition.

Examples of the organic dye that can form a salt with an acid, include triphenylmethane dye, cyanine dye, diazo dye, and styryl dye. Specific examples thereof include Crystal Violet, Ethyl Violet, Methyl Violet, Methylene Blue, Victoria Blue BH, Victoria Pure Blue BOH, Oil Blue #603, Malachite Green, Oil Green BG, Brilliant Green, fuchsin, eosin, Rhodamine B, Oil Pink #312, Oil Red 5B, Oil Black BS, Oil Yellow #101, phenolphthalein, Cresol Red, auramine, Leucocrystal Violet, and Leucomalachite Green. The amount thereof is not more than 15% by weight based on the photosensitive composition.

Examples of the dye as the image-coloring agent include stilbene dyes, benzophenone dyes, benzoquinone dyes, naphthoquinone dyes, squarylium dyes, oxidation dyes, sulfide dyes, reactive dyes, and fluorescent whitening dyes. The amount thereof is not more than 15% by weight based on the positive-working photosensitive composition.

Examples of various resins having a hydrophobic group to improve the inking properties of the image include octylphenol-formaldehyde resins, t-butylphenol-formaldehyde resins, t-butylphenol-benzaldehyde resins, a rosin-modified novolac resins, and esters of these modified novolac resins.

Examples of the plasticizer to improve the pliability of the coating film include diethyl phthalate, dioctyl phthalate, butyl glycolate, tricresyl phosphate, and dioctyl adipate.

Examples of the publicly-known resins added to improve the wear resistance of the coating film include polyvinyl acetal resins, polyurethane resins, epoxy resins, vinyl chloride resins, nylon, polyester resins, and acrylic resins.

The amount of each of these additives is usually not more than 15% by weight based on the positive-working photosensitive composition, and the total amount thereof is not more than 40% by weight.

### (5) Negative-working photosensitive composition containing a compound that generates an acid by heat, an acid crosslinking agent, and a photothermal conversion material, for an infrared laser

Examples of the compound that generates an acid by heat include publicly-known onium salts such as ammonium salts, phosphonium salts, iodonium salts, sulfonium salts, or selenonium salts, organic halogen compounds, photo acid generators having an o-nitrobenzyl type protective group, and disulfone compounds. Particularly, a trihaloalkyl compound and a diazonium salt compound can be preferably used because high sensitivity can be obtained. If necessary, two or more kinds of compounds that generate an acid by heat may be used in combination.

Examples of the trihaloalkyl compound include a trihalomethyl-s-triazine compound as described in U.S. Patent No. 4,239,850, and an oxadiazole compound and a tribromomethylsulfonyl compound as described in U.S. Patent No. 4,212,970.

As the diazonium salt compound, the above photosensitive diazonium compound can be used.

The amount of the compound that generates an acid by heat is preferably in a range of from 0.01 to 50% by weight, and, in particular, preferably from 0.1 to 20% by weight, based on the solid content of the negative-working photosensitive composition. When the amount of the compound that generates an acid by heat is less than 0.01 % by weight, it is impossible to expect the generation of an acid sufficient to crosslink with an acid crosslinking agent. On the other hand, when the amount exceeds 50% by weight, the solubility in a developer of the non-image portion is drastically lowered.

The acid crosslinking agent is not specifically limited and may be any one as long as it is crosslinked and made to be insoluble by the catalytic action of the acid generated from the compound that generates an acid by heat.

Examples of the acid crosslinking agent include amino compounds having at least two groups from among a methylol group, an alkoxymethyl group, and an acetoxymethyl group. Specific examples thereof include a melamine derivative such as methoxymethylated melamine, benzoguanamine derivatives, or glycol uril derivatives, urea resin derivatives, and resol resins.

Among these, a resol resin is preferably used because the solubility of the image portion/non-image portion in the developer and contrast are enhanced.

The amount of the acid crosslinking agent is preferably in a range of from 5 to 70% by weight based on the solid content of the negative-working photosensitive composition. If necessary, two or more kinds of compounds (b), which are crosslinked with an acid, may be used in combination.

As the photothermal conversion material, pigments or dyes described for the positive-working photosensitive composition for an infrared laser (4) can be used.

The amount of the photothermal conversion material is preferably in a range of from 3 to 20% by weight based on the solid content of the negative-working photosensitive composition. When the amount of the photothermal conversion material is less than 3% by weight, sufficient heat cannot be generated even if light is absorbed to generate heat. On the other hand, when the amount exceeds 20% by weight, the heat generated is substantially saturated, and the addition effect is not enhanced. Therefore, there are not preferred.

In the negative-working photosensitive composition for an infrared laser, publicly-known additives, such as dyes as image coloring agents, plasticizers, and stability modifiers, can be optionally added in the same manner as described in the case of the above negative-working photosensitive composition (2).

The amount of these various additives varies depending on the purpose, but is preferably not more than 30% by weight based on the solid content of the photosensitive composition.

Since the above photosensitive composition contains a resin having a barbituric acid group in the side chain, a coating film having excellent solvent resistance can be obtained. Since the coating film is hardly corroded by the solvent, such a coating film is also excellent in wear resistance.

### Photosensitive planographic printing plate

The photosensitive planographic printing plate of the present invention is generally composed of a support, and a photosensitive layer made of the above photosensitive composition provided on the support.

The photosensitive layer made of the photosensitive composition for an infrared laser may be referred to as a heat-sensitive layer because it utilizes heat generated by irradiation with light, but is referred to as a photosensitive layer for convenience.

Examples of the support include metal plates made of aluminum, zinc, copper, stainless steel, and iron; plastic films made of polyethylene terephthalate, polycarbonate, polyvinyl acetal, and polyethylene; composite materials obtained by providing a metal layer on a paper or plastic film melt-coated with a synthetic resin or coated with a synthetic resin solution using a technology such as vacuum deposition or lamination; and materials used as the support of the printing plate. Among these supports, an aluminum support and a composite support coated with aluminum are preferable.

The surface of the aluminum support is preferably subjected to a surface treatment to enhance water retention and improve the adhesion with the photosensitive layer. Examples of the surface treatment include brushing, ball polishing, electrolytic etching, chemical etching, liquid homing, a roughening treatment such as sand blasting, and combinations thereof. Among these, a roughening treatment including electrolytic etching is preferable.

In the electrolytic bath used during the electrolytic etching, an aqueous solution containing an acid, an alkali, or a salt thereof, or an aqueous solution containing an organic solvent is used. Among these, an electrolytic solution containing hydrochloric acid, nitric acid, or a salt thereof is preferred.

If necessary, the aluminum support subjected to the roughening treatment is subjected to a desmutting treatment using an aqueous solution of an acid or alkali. The aluminum support thus obtained is preferably anodized. Particularly, an anodizing treatment performed in a bath containing sulfuric acid or phosphoric acid is preferred.

If necessary, the aluminum support can be subjected to a silicate treatment (sodium silicate, potassium silicate), a treatment with potassium zirconate fluoride, a phosphomolybdate treatment, an alkyl titanate treatment, a polyacrylate treatment, a polyvinyl sulfonate treatment, a phosphonate treatment, a phytate treatment, a treatment with a salt of a hydrophilic organic polymer compound and a divalent metal as described in Japanese Unexamined Patent Application, First Publication No. Sho 58-16839 and Japanese Unexamined Patent Application, First Publication No. Sho 58-18291, a hydrophilization treatment by means of undercoating of a water-soluble polymer having a sulfonic acid group as described in Japanese Unexamined Patent Application, First Publication No. Sho 59-101651, a coloring treatment with an acidic dye as described in Japanese Unexamined Patent Application, First Publication No. Sho 60-64352, and a treatment such as silicate deposition as described in U.S. Patent No. 3,658,662.

It is preferred that the aluminum support be subjected to an anodizing treatment after a roughening treatment (graining treatment) or a sealing treatment. The sealing treatment is performed by dipping the aluminum support in a hot water or hot aqueous solution containing an inorganic or organic salt, or a steam bath.

The photosensitive planographic printing plate of the present invention is produced by applying a coating solution prepared by dissolving or dispersing a photosensitive composition in an organic solvent on the surface of a support, and drying the coating solution to form a photosensitive layer on the support.

As the organic solvent in which the photosensitive composition is dissolved or dispersed, any publicly known and conventional organic solvents can be used. Among these, an organic solvent having a boiling point in a range of from 40 to 200°C, and particularly from 60 to 160°C, is selected because of advantages during drying.

Examples of the organic solvent include alcohols such as methyl alcohol, ethyl alcohol, n- or isopropyl alcohol, n- or isobutyl alcohol, and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone, and acetylacetone; hydrocarbons such as hexane, cyclohexane, heptane, octane, nonane, decane, benzene, toluene, xylene, and methoxybenzene; acetic esters such as ethyl acetate, n- or isopropyl acetate, n- or isobutyl acetate, ethylbutyl acetate, and hexyl acetate; halides such as methylene dichloride, ethylene dichloride, and monochlorobenzene; ethers such as isopropyl ether, n-butyl ether, dioxane, dimethyldioxane, and tetrahydrofuran; polyhydric alcohols and derivatives thereof, such as ethylene glycol, METHYLCELLOSOLVE®, METHYLCELLOSOLVE ACETATE®, ETHYLCELLOSOLVE®, DIETHYLCELLOSOLVE®, CELLOSOLVE® acetate, BUTYLCELLOSOLVE®, BUTYLCELLOSOLVE® acetate, methoxymethoxy ethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol, and 1-methoxy-2-propanol; and special solvents such as dimethyl sulfoxide, N,N-dimethylformamide, N,N-dimethylacetamide, methyl lactate, and ethyl lactate. These organic solvents are used alone or in combination. The solid content in the coating solution is preferably controlled in a range of from 2 to 50% by weight.

In the coating solution, additives to improve the coatability may be added. Examples of the additive to improve the coatability include cellulose alkyl ethers, ethylene oxide surfactants, fluorine surfactants, and silicone surfactants. Specific examples of the fluorine surfactants include anionic fluorine surfactants such as a perfluoroalkyl group-containing carboxylate, a perfluoroalkyl group-containing sulfonate, a perfluoroalkyl group-containing sulfuric ester, and a perfluoroalkyl group-containing phosphate; cationic fluorine surfactants such as a perfluoroalkyl group-containing amine salt and a perfluoroalkyl group-containing quaternary ammonium salt; amphoteric fluorine surfactants such as a perfluoroalkyl group-containing carboxybetaine and a perfluoroalkyl group-containing aminocarboxylate; and perfluoroalkyl group-containing oligomers, perfluoroalkyl group-containing polymers, and perfluoroalkyl group-containing sulfoamide polyethylene glycol adducts.

As the method of coating the coating solution, for example, roll coating, dip coating, air knife coating, gravure coating, gravure offset coating, hopper coating, blade coating, wire doctor coating, and spray coating methods can be used. The coating amount of the coating solution is preferably in a range of 10 to 100 ml/m².

The photosensitive composition applied on the support is usually dried by means of the heated air. The heating is preferably performed in a range of 30 to 200°C, and particularly preferably from 40 to 140°C. Not only a method of maintaining the drying temperature at the same temperature during drying, but also a method of rising the temperature stepwise can be carried out.

In addition, preferred results may be obtained by dehumidification of the drying air. The heated air is preferably supplied to the surface to be coated at a rate in a range of from 0.1 to 30 m/seconds, and particularly preferably from 0.5 to 20 m/seconds.

The coating amount of the photosensitive composition is usually about 0.5 to about 5 g/m² on a dry weight basis.

The photosensitive planographic printing plate having a photosensitive layer made of each of the photosensitive compositions (1) to (3) is converted into a planographic printing plate having a corresponding image formed on the support by exposing the photosensitive layer to light in a state of close contact with a silver salt mask film and developing with a developer, thereby to dissolve and remove the non-image portion.

Examples of the preferred light source used in the exposure include a carbon arc lamp, a mercury lamp, a metal halide lamp, a xenon lamp, a chemical lamp, and a laser.

The photosensitive planographic printing plate made of each of the photosensitive compositions (3) to (5) can be used as a so-cafled computer-to-plate (CTP) which can directly write an image on a plate based on digital information from the computer using a laser.

Examples of the light source of the laser used in the present invention include a laser which emits light in the ultraviolet, visible, or infrared range having a wavelength in a range of from 300 nm to 3000 nm. Specific examples thereof include an Ar ion laser (488 nm, 515 nm), FD-YAG laser (532 nm), He-Ne laser (633 nm, 543 nm, 364 nm), InGaN semiconductor laser (360 to 450 nm, particularly 405 nm), various semiconductor lasers wherein the oscillation wavelength is in a range of from 760 to 950 nm, and YAG laser (oscillation wavelength: 1064 nm). Any laser can be used by selecting the pigments or dye, which can absorb light having a specific wavelength of the light source to convert light into heat, or sensitizing pigments among those described above, and adding them to the photosensitive composition.

The photosensitive planographic printing plate of the present invention is converted into a planographic printing plate having an image portion by writing an image on a photosensitive layer using a laser, subsequently carrying out a developing treatment thereon, and removing the non-image portion using a wet method. An example of the developer used in the developing treatment includes an aqueous alkali solution (basic aqueous solution).

Examples of the alkali agent used in the developer include inorganic alkali compounds such as sodium silicate, potassium silicate, potassium hydroxide, sodium hydroxide, lithium hydroxide, a sodium, potassium, or ammonium salt of secondary or tertiary phosphoric acid, sodium metasilicate, sodium carbonate, and ammonia; and organic alkali compounds such as monomethylamine, dimethylamine, trimethylamine, monoethylamine, diethylamine, triethylamine, monoisopropylamine, diisopropylamine, n-butylamine, di-n-butylamine, monoethanolamine, diethanolamine, triethanolamine, ethyleneimine, and ethylenediamine.

The content of the alkali agent in the developer is preferably in a range of from 0.005 to 30% by weight, and particularly preferably from 0.05 to 15% by weight. When the content of the alkali agent in the developer is less than 0.005% by weight, the development tends to be poor. On the other hand, when the amount is more than 30% by weight, an adverse effect such as corrosion of the image portion tends to be exerted during the development. Therefore, they are not preferred.

An organic solvent can be added to the developer. Examples of the organic solvent which can be added to the developer include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methyl phenyl carbitol, n-amyl alcohol, methylamyl alcohol, xylene, methylene dichloride, ethylene dichloride, and monochlorobenzene.

The amount of the organic solvent to be added to the developer is preferably not more than 20% by weight, and particularly preferably not more than 10% by weight.

Furthermore, in the developers described above, for example, water-soluble sulfites such as lithium sulfite, sodium sulfite, potassium sulfite, and magnesium sulfite; aromatic hydroxy compounds such as an alkali-soluble pyrazolone compound, an alkali-soluble thiol compound, and methylresorcin; water softeners such as a polyphosphate and an aminopolycarboxylate; and various surfactants such as anionic surfactants, nonionic surfactants, cationic surfactants, amphoteric surfactants, and fluorine surfactants such as sodium isopropylnaphthalene sulfonate, sodium n-butylnaphthalene sulfonate, sodium N-methyl-N-pentadecyl aminoacetate, and sodium lauryl sulfate, and various deformers can be optionally used.

As the developer, commercially available developers for positive-working PS plates or negative-working PS plates can be practically used. Specifically, a developer prepared by diluting a commercially available concentrated developer for positive-working PS plates or negative-working PS plates, 1 to 200 times, can be used as the developer in the present invention.

The temperature of the developer is preferably in a range of from 15 to 40°C, while the dipping time is preferably in a range of from 1 second to 5 minutes. If necessary, it is possible to slightly rub the surface during development.

After completion of the development, the planographic printing plate is subjected to washing with water and/or is subjected to a treatment with an aqueous desensitizer (finishing gum). The aqueous desensitizer includes, for example, an aqueous solution of a water-soluble natural polymer such as gum arabic, dextrin, or carboxymethylcellulose, or an aqueous solution of a water-soluble synthetic polymer such as polyvinyl alcohol, polyvinyl pyrrolidone, or polyacrylic acid. If necessary, an acid or a surfactant is added to the aqueous desensitizer. After subjecting to the treatment with the desensitizer, the planographic printing plate is dried, and is then used as a printing plate during printing.

Because the photosensitive composition constituting the photosensitive layer contains an alkali-soluble resin having a barbituric acid group in the side chain, the photosensitive planographic printing plate has excellent solvent resistance, particularly resistance to a UV ink-washing oil used in UV ink printing, and excellent press-life.

### Industrial Applicability

The photosensitive composition of the present invention can be used for various purposes, such as a photoresists, in addition to the planographic printing plates.

### EXAMPLES

The present invention will be described in more detail by way of examples, but the present invention is not limited to the following examples. *Vinyl polymer having a barbituric acid group in the side chain*

### Synthesis Examples 1 to 4 and 8 to 10

### (A) Method using a copolymerization reaction

While stirring, 19.00 g of acryloyl chloride and 24.42 g of 4-hydroxybenzaldehyde were added to 100 g of tetrahydrofuran to dissolve them. While cooling the resulting solution in a water bath while stirring, 22.22 g of triethylamine was added dropwise to the solution over 30 minutes, and the mixture was continuously stirred for 3 hours to synthesize a compound (j) represented by the formula (VII) shown below. Subsequently, to the solution, 25.62 g of barbituric acid and 100 g of hot water were added, followed by stirring at 60°C for 3 hours. After the resulting solution was poured into 1000 ml of water, the precipitate was recovered by filtration, and was then dried under reduced pressure to obtain 57 g of a compound (k) represented by the following formula (VII) (R³ = H, hereinafter referred to as AHB).

In the same manner as described above, except that 21.94 g of methacryloyl chloride was used in place of acryloyl chloride, 59 g of a compound (k) (R³ = CH₃, hereinafter referred to as MHB) was obtained.

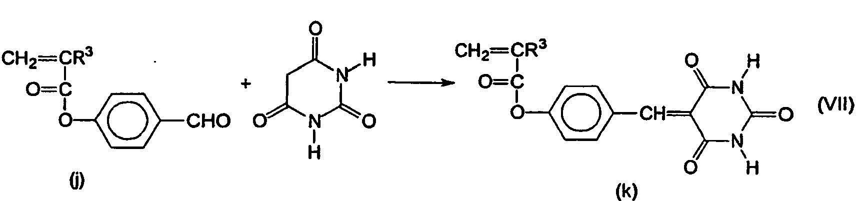

In a flask equipped with a cooling tube, a nitrogen introducing tube, a thermometer, a dropping funnel, and a stirrer, 132 parts by weight of N,N-dimethylacetamide was charged, and N,N-dimethylacetamide was heated to 80°C while stirring while introducing a nitrogen gas into the flask. A monomer solution prepared by dissolving a monomer in the amount shown in Table 1 and 2.4 parts by weight of azobisisobutyronitrile in 132 parts by weight of N,N-dimethylacetamide was added dropwise to N,N-dimethylacetamide in the flask while stirring over one hour, and the mixture was continuously stirred at 80°C for 3 hours. After the resulting solution was poured into water, the precipitate was recovered by filtration, and was then dried under reduced pressure to obtain a vinyl polymer having a barbituric acid group in the side chain.

### Synthesis Examples 5 to 7

### (B) Method using a modification reaction

In a flask equipped with a cooling tube, a nitrogen introducing tube, a thermometer, a dropping funnel, and a stirrer, 120 parts by weight of N,N-dimethylacetamide was charged. While stirring, 12.72 parts by weight of acryloyl chloride and 17.16 parts by weight of 4-hydroxybenzaldehyde were dissolved in N,N-dimethylacetamide. While stirring, 14.88 parts by weight of triethylamine was added dropwise to the solution over one hour while cooling the solution in a water bath, and the mixture was continuously stirred for 3 hours to synthesize a compound (j) represented by the formula (VII) shown below.

In another flask, 120 parts by weight of N,N-dimethylacetamide was charged and was then heated to 80°C while introducing a nitrogen gas. Separately, a monomer other than AHB in the amount shown in Table 1 and 3.2 parts by weight of azobisisobutyronitrile were dissolved in the solution containing the compound (j) described above to prepare a monomer solution. While stirring, the monomer solution was added dropwise to the solution in the,flask heated to 80°C over one hour, and the mixture was continuously stirred at 80°C for 3 hours to obtain a vinyl polymer having an aldehyde group in the side chain. After cooling the resulting solution, 18.0 parts by weight of barbituric acid and 10 parts by weight of hot water were added to the solution in the flask while introducing air into the flask in place of the nitrogen gas, followed by stirring at 60°C for 2 hours. After the solution was poured into water, the precipitate was recovered by filtration, and was then dried under reduced pressure to obtain a vinyl polymer having a barbituric acid group in the side chain.

### Synthesis Examples 11 to 15

In the same manner as described in Synthesis Examples 5 to 7, except that 22.28 parts by weight of acryloyl chloride, 30.04 parts by weight of 4-hydroxybenzaldehyde, and 26.08 parts by weight of triethylamine were used, vinyl polymers having a barbituric acid group in the side chain were obtained.

### Synthesis Example 16

In the same manner as described in Synthesis Examples 5 to 7, except that 7.92 parts by weight of acryloyl chloride, 10.68 parts by weight of 4-hydroxybenzaldehyde, and 9.28 parts by weight of triethylamine were used, a vinyl polymer having a barbituric acid group in the side chain was obtained.

### Synthesis Examples 17 and 18

In the same manner as described in Synthesis Examples 5 to 7, except that 4.76 parts by weight of acryloyl chloride, 6.40 parts by weight 4-hydroxybenzaldehyde, and 5.56 parts by weight of triethylamine were used, vinyl polymers having a barbituric acid group in the side chain were obtained.

### Synthesis Example 19

In the same manner as described in Synthesis Examples 5 to 7, except that 9.79 parts by weight of acryloyl chloride, 13.22 parts by weight of 4-hydroxybenzaldehyde, and 11.48 parts by weight of triethylamine were used, a vinyl polymer having a barbituric acid group in the side chain was obtained. *Vinyl polymer having a urea bond in the side chain*

### Synthesis Example 20

In the same manner as described in Synthesis Example 2, except that 40 parts by weight of the following compound (VIII) were used in place of AHB, a vinyl polymer having a urea bond in the side chain was obtained.

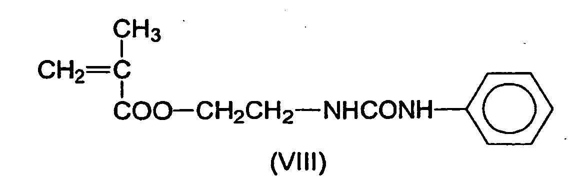

### Polyurethane having a barbituric acid group in the side chain

### Synthesis Example 21

2,4-dihydroxybenzaldehyde (12.43 g, 0.09 mol), hexamethylene diisocyanate (15.14 g, 0.09 mol), and di-n-butyltin dilaurate (0.06 g) were dissolved in N,N-dimethylacetamide (50 g), followed by stirring for 5 hours. Then, barbituric acid (11.53 g, 0.09 mol) was added, followed by further stirring for 4 hours. The reaction mixture was poured into water (500 ml), and the resulting precipitate was washed with water, was collected by filtration, and was then dried under reduced pressure.

### Synthesis Example 22

2,4- dihydroxybenzaldehyde (8.29 g, 0.06 mol), m-xylylene diisocyanate (10.16 g, 0.054 mol), and di-n-butyltin dilaurate (0.06 g) were dissolved in N,N-dimethylacetamide (40 g), followed by stirring for 5 hours. Then, barbituric acid (7.69 g, 0.06 mol) was added, followed by further stirring for 4 hours. The reaction mixture was poured into water (500 ml), and the resulting precipitate was washed with water, was collected by filtration, and was then dried under reduced pressure.

### Synthesis Example 23

2,4- dihydroxybenzaldehyde (12.43 g, 0.09 mol), isophorone diisocyanate (18.01 g, 0.08 mol), and di-n-butyltin dilaurate (0.06 g) were dissolved in N,N-dimethylacetamide (50 g), followed by stirring for 5 hours. Subsequently, barbituric acid (11.53 g, 0.09 mol) was added, followed by further stirring for 4 hours. The reaction mixture was poured into water (500 ml), and the resulting precipitate washed with water, collected by filtration, and then dried under reduced pressure.

### Synthesis Example 24

2,4- dihydroxybenzaldehyde (12.43 g, 0.09 mol), hexamethylene diisocyanate (14.11 g, 0.08 mol) and di-n-butyltin dilaurate (0.06 g) were dissolved in N,N-dimethylacetamide (50 g), followed by stirring for 5 hours. Subsequently, barbituric acid (11.53 g, 0.09 mol) was added, followed by further stirring for 4 hours. The reaction mixture was poured into water (500 ml), and the resulting precipitate washed with water, collected by filtration, and then dried under reduced pressure.

### Polyester having a barbituric acid group in the side chain

### Synthesis Example 25

2,4- dihydroxybenzaldehyde (12.43 g, 0.09 mol) and sebacic acid chloride. (20.57 g, 0.086 mol) were dissolved in N,N-dimethylacetamide (50 g), and subsequently triethylenediamine (18.24 g, 0.1806 mol) was added dropwise, followed by stirring for one hour. Subsequently, barbituric acid (11.53 g, 0.09 mol) was added, followed by further stirring for 4 hours. The reaction mixture was poured into water (500 ml), and the resulting precipitate washed with water, collected by filtration, and then dried under reduced pressure.

With respect to the resins of Synthesis Examples 1 to 25, the solubility in the developer was examined. As the developer, a solution prepared by diluting PD-1 (manufactured by Kodak Polychrome Graphics Co., Ltd.) with water 8 times was used. In the table, the symbol "O" means a rating wherein the resin is rapidly dissolved in the developer, the symbol "Δ" means a rating wherein the resin is dissolved in the developer at a low dissolution rate, and the symbol "X" means a rating wherein the resin is not dissolved in the developer. Abbreviations used in the table are as follows: AN - acrylonitrile; MAAm - methacrylamide; PMI - N-phenylmaleimide; APK - 2-[N'-(4-hydroxyphenyl)ureido]ethyl methacrylate; and MMA - methyl methacrylate

**Table 1**

| Synthesis Examples | Method | Amount (parts by weight) | | | | | | | | Solubility |
|---|---|---|---|---|---|---|---|---|---|---|
| | | AHB | MHB | (VIII) | AN | MAAm | PMI | APK | MMA | |
| 1 | A | 30.0 | | | 50.0 | 10.0 | 10.0 | | | Δ |
| 2 | A | 40.0 | | | 40.0 | 10.0 | 10.0 | | | ○ |
| 3 | A | 50.0 | | | 40.0 | | 10.0 | | | ○ |
| 4 | A | | 40.0 | | 40.0 | 10.0 | 10.0 | | | ○ |
| 5 | B | 40.0 | | | 40.0 | 10.0 | 10.0 | | | ○ |
| 6 | B | 40.0 | | | 40.0 | 5.0 | | | 15.0 | ○ |
| 7 | B | 40.0 | | | 40.0 | | | | 20.0 | ○ |
| 8 | A | 70.0 | | | 10.0 | | | | 20.0 | Δ |
| 9 | A | 70.0 | | | 10.0 | | 20.0 | | | Δ |
| 10 | A | | 70.0 | | 10.0 | | 20.0 | | | Δ |
| 11 | B | 70.0 | | | 10.0 | | | | 20.0 | Δ |
| 12 | B | 70.0 | | | 10.0 | | 20.0 | | | ○ |
| 13 | B | 70.0 | | | 20.0 | | | | 10.0 | ○ |
| 14 | B | 70.0 | | | 20.0 | | 10.0 | | | ○ |
| 15 | B | 70.0 | | | 30.0 | | | | | ○ |
| 16 | B | 25.0 | | | 35.0 | | | 40.0 | | ○ |
| 17 | B | 15.0 | | | 45.0 | | | 40.0 | | ○ |
| 18 | B | 15.0 | | | 45.0 | | | 40.0 | | ○ |
| 19 | B | 30.0 | | | 40.0 | | | 30.0 | | ○ |
| 20 | - | | | 40.0 | 40.0 | 10.0 | 10.0 | | | × |
| 21 | | | | | | | | | | ○ |
| 22 | | | | | | | | | | ○ |
| 23 | | | | | | | | | | ○ |
| 24 | | | | | | | | | | ○ |
| 25 | | | | | | | | | | ○ |

### Aluminum support

An aluminum sheet having a thickness of 0.24 mm was degreased with an aqueous solution of sodium hydroxide, and was then electrolytically polished in a 20% hydrochloric acid bath to obtain a grained sheet having a center line average roughness (Ra) of 0.5 µm. The resulting grained sheet was anodized in a 20% sulfuric acid bath at a current density of 2 A/dm² to form an oxide film of 2.7 g/m², which was washed with water, and was then dried to obtain an aluminum substrate.

### Positive-working photosensitive planographic printing plate

### Examples 1 to 4 and Comparative Example 1

A coating solution with the composition shown in Table 2 was prepared, applied on the aluminum support using a bar coater, rod number #12, and then dried at 120°C for 40 seconds to obtain a positive-working photosensitive planographic printing plate. The coating weight after drying was 2.0±0.2 g/m².

**Table 2**

| | Example 1 | Example 2 | Example 3 | Example 4 | Comparative Example 1 |
|---|---|---|---|---|---|
| Ester compound of 1,2-naphthoquinonediazide-5-sulfonyl chloride and 2,3,4-trihydroxybenzophenone | 0.20 g | 0.20 g | 0.20 g | 0.20 g | 0.20 g |
| Novolac resin #1 | 0.15 g | 0.15 g | 0.15 g | 0.15 g | 0.75 g |
| 2-(4-methoxynaphthyl)-4,6-bis(trichloromethyl)-s-triazine | 0.01 g | 0.01 g | 0.01 g | 0.01 g | 0.01 g |
| Victoria Pure Blue BOH (manufactured by Hodogaya Chemical Co., Ltd.) | 0.01 g | 0.01 g | 0.01 g | 0.01 g | 0.01 g |
| Synthesis Example 5 | 0.60 g | | | | |
| Synthesis Example 12 | | 0.60 g | | | |
| Synthesis Example 13 | | | 0.60 g | | |
| Synthesis Example 16 | | | | 0.60 g | |
| N,N-dimethylacetamide | 1.00 g | 1.00 g | 1.00 g | 1.00 g | 1.00 g |
| METHYLCELLOSOLVE® | 9.00 g | 9.00 g | 9.00 g | 9.00 g | 9.00 g |

### Sensitivity

A step wedge (manufactured by Ugura) was brought into close contact with each of the resulting photosensitive planographic printing plates. Using an exposing machine, P-824-GX (manufactured by DAINIPPON SCREEN MFG. CO., LTD.), wherein a metal halide lamp having an output of 3 kW is provided at a distance of 1 m from the photosensitive planographic printing plate, the photosensitive planographic printing plate was exposed to light under the conditions of a dose of 80 mJ/cm². Subsequently, using a processor PD-912 (manufactured by DAINIPPON SCREEN MFG. CO., LTD.) and a developer prepared by diluting a developer for posi-plate, PD-1 (manufactured by Kodak Polychrome Graphics Co., Ltd.), with water 8 times, the exposed photosensitive planographic printing plate was developed at 30°C for 12 seconds. Subsequently, the clear step number/solid step number of gray scale was read, and a minimum line width (µm) of the completely reproduced microline was read. The results are shown in Table 3.

### Washing oil resistance

Two samples were cut from the photosensitive planographic printing plate, and were dipped in a Daicure washing oil A (A in the table) and a Daicure roller washing oil (B in the table) (both are manufactured by DAINIPPON INK & CHEMICALS Co., Ltd.) used during printing at room temperature for 30 minutes, and then the washing oil resistance was evaluated. The results are shown in Table 3. In the table, the symbol "O" means a rating wherein no change was observed in the streak portion, and the symbol "X" means a rating wherein the streak portion is corroded with the washing oil.

### Press-life

A film of solid- and dot-positive images and a step wedge were brought into close contact with the photosensitive planographic printing plate. Using an exposing machine, P-824-GX (manufactured by DAINIPPON SCREEN MFG. CO., LTD.), wherein a metal halide lamp having an output of 3 kW is provided at a distance of 1 m from the photosensitive planographic printing plate, the photosensitive planographic printing plate was exposed to light for an exposure time adjusted to 4 steps clear. Using a processor, PD-912 (manufactured by DAINIPPON SCREEN MFG. CO., LTD.), and a developer prepared by diluting a developer for posi-plate, PD-1 (manufactured by Kodak Polychrome Graphics Co., Ltd.), with water 8 times, the exposed photosensitive planographic printing plate was developed at 30°C for 12 seconds, and a finishing gum, PF-2 (manufactured by Kodak Polychrome Graphics Co., Ltd.), was applied on the plate. Using each of the resulting planographic printing plates, printing was performed, and then the press-life was evaluated from the final number of printed pages obtained with accurate printing. The results are shown in Table 3. R-700 (manufactured by MAN ROLAND) was used as the printing press, "Daicure Scepter Black" (manufactured by DAINIPPON INK & CHEMICALS Co., Ltd.) was used as UV ink, and a solution prepared by diluting "NA-108W" (manufactured by DAINIPPON INK & CHEMICALS Co., Ltd.) 100 times was used as a fountain solution.

**Table 3**

| | | Sensitivity | | Washing oil resistance | | Press-life (number of pages printed) |
|---|---|---|---|---|---|---|
| | | Gray scale | Microline | A | B | |
| Example 1 | Example 5 | 4.5/11 | 12 | ○ | ○ | 70,000 |
| Example 2 | Synthesis Example 12 | 4.5/11 | 13 | ○ | ○ | 75,000 |
| Example 3 | Synthesis Example 13 | 4.5/11 | 14 | ○ | ○ | 70,000 |
| Example 4 | Synthesis Example 16 | 4.5/11 | 13 | ○ | ○ | 70,000 |
| Comparative Example 1 | - | 4.5/10 | 12 | × | × | 3,000 |

As is apparent from the results of Examples 1 to 4, the positive-working photosensitive planographic printing plates, using the photosensitive composition containing the alkali-soluble resin having a barbituric acid group in the side chain, are excellent in washing oil resistance and press-life.

### Negative-working photosensitive planographic printing plate

### Examples 5 and 6

A coating solution having the composition shown in Table 4 was prepared, and the coating solution was applied on the aluminum support using a bar coater, rod number #12, and was then dried at 100°C for 3 minutes to obtain a negative-working photosensitive planographic printing plate. The coating weight after drying was 2.0 ± 0.2 g/m².

**Table 4**

| | Example 5 | Example 6 |
|---|---|---|
| Hexafluorophosphate of condensate of p-diazodiphenylamine and formaldehyde | 5.0 g | 5.0 g |
| Synthesis Example 5 | 50.0 g | |
| Synthesis Example 13 | | 50.0 g |
| Dipentaerythritol hexaacrylate | 15.0 g | 15.0 g |
| 2-(4-methoxynaphthyl)-4,6-bis(trichloromethyl)-s-triazine | 2.5 g | 2.5 g |
| Victoria Pure Blue BOH (manufactured by Hodogaya Chemical Co., Ltd.) | 1.0 g | 1.0 g |
| METHYLCELLOSOLVE® | 500 g | 500 g |
| Methyl ethyl ketone | 200 g | 200 g |
| N,N-dimethylacetamide | 100 g | 100 g |
| Methanol | 200 g | 200 g |

### Sensitivity

A step wedge (manufactured by Ugura) was brought into close contact with each of the resulting photosensitive planographic printing plates. Using an exposing machine, P-824-GX (manufactured by DAINIPPON SCREEN MFG. CO., LTD.), wherein a metal halide lamp having an output of 3 kW is provided at a distance of 1 m from the photosensitive planographic printing plate, the photosensitive planographic printing plate was exposed to light under the conditions of a dose of 80 mJ/cm². Subsequently, using a processor, PD-912 (manufactured by DAINIPPON SCREEN MFG. CO., LTD.), and a developer prepared by diluting a developer for nega-plate, ND-1 (manufactured by Kodak Polychrome Graphics Co., Ltd.), with water 4 times, the exposed photosensitive planographic printing plate was developed at 30°C for 19 seconds. Subsequently, the clear step number/solid step number of gray scale was read, and a minimum line width (µm) of the completely reproduced microline was read. The results are shown in Table 5.

### Washing oil resistance

Using an exposing machine, P-824-GX (manufactured by DAINIPPON SCREEN MFG. CO., LTD.), wherein a metal halide lamp having an output of 3 kW is provided at a distance of 1 m from the photosensitive planographic printing plate, the photosensitive planographic printing plate was exposed to light for an exposure time adjusted to yield 3 steps solid as the photosensitivity. Subsequently, using a processor, PD-912 (manufactured by DAINIPPON SCREEN MFG. CO., LTD.), and a developer prepared by diluting a developer for nega-plate, ND-1 (manufactured by Kodak Polychrome Graphics Co., Ltd.), with water 4 times, the exposed photosensitive planographic printing plate was developed at 30°C for 19 seconds to obtain a planographic printing plate. Two samples were cut from the planographic printing plate, and were dipped in a Daicure washing oil A (A in the table) and a Daicure roller washing oil (B in the table) (both are manufactured by DAINIPPON INK & CHEMICALS Co., Ltd.) used during printing, at room temperature for 30 minutes, and then the washing oil resistance was evaluated. The results are shown in Table 5. In the table, the symbol "○" means a rating wherein no change was observed in the streak portion, and the symbol "X" means a rating wherein the streak portion is corroded with the washing oil.

### Press-life

A film of solid- and dot-negative images and a step wedge were brought into close contact with the photosensitive planographic printing plate. Using an exposing machine P-824-GX (manufactured by DAINIPPON SCREEN MFG. CO., LTD.), wherein a metal halide lamp having an output of 3 kW is provided at a distance of 1 m from the photosensitive planographic printing plate, the photosensitive planographic printing plate was exposed to light for an exposure time adjusted to 3 steps solid. Subsequently, using a processor, PD-912 (manufactured by DAINIPPON SCREEN MFG. CO., LTD.), and a developer prepared by diluting a developer for nega-plate, ND-1 (manufactured by Kodak Polychrome Graphics Co., Ltd.), with water 4 times, the exposed photosensitive planographic printing plate was developed at 30°C for 19 seconds, and a finishing gum, PF-2 (manufactured by Kodak Polychrome Graphics Co., Ltd.), was applied on the plate. Using each of the resulting planographic printing plates, printing was performed, and then the press-life was evaluated from the final number of printed pages obtained with accurate printing. The results are shown in Table 5. Here, R-700 (manufactured by MAN Roland) was used as a printing press, "Daicure Scepter Black" (manufactured by DAINIPPON INK & CHEMICALS Co., Ltd.) was used as UV ink, and a solution prepared by diluting "NA-108W" (manufactured by DAINIPPON INK & CHEMICALS Co., Ltd.) 100 times was used as a fountain solution.

**Table 5**

| | | Sensitivity | | Washing oil resistance | | Press-life (number of pages printed) |
|---|---|---|---|---|---|---|
| | | Gray scale | Microline | A | B | |
| Example 5 | Synthesis Example 5 | 10/3 | 14 | ○ | ○ | 250,000 |
| Example 6 | Synthesis Example 13 | 10/3 | 14 | ○ | ○ | 250,000 |

As is apparent from the results of Examples 5 and 6, the negative-working photosensitive planographic printing plates using the photosensitive composition containing the alkali-soluble resin having a barbituric acid group in the side chain are excellent in washing oil-resistance and press-life.

### Positive-working photosensitive planographic printing plate for an infrared laser

### Examples 7 to 23 and Comparative Example 2

In a 200 ml flask, 100 g of METHYLCELLOSOLVE® and 50 g of dimethylacetamide were charged and, after adding the vinyl polymer having a barbituric acid group in the side chain of Synthesis Example 3, the vinyl polymer was completely dissolved by stirring at room temperature for one hour. To the solution, 1.5 g of infrared dye 1 (Formula (IX) below, manufactured by Kodak Chemical Company) and 5 drops of DC190 (surfactant, manufactured by Dow Coming Corporation) were added, followed by stirring at room temperature for 30 minutes. The solution was filtered through a filter having an opening size of 10 µm to obtain a coating solution of Example 7.

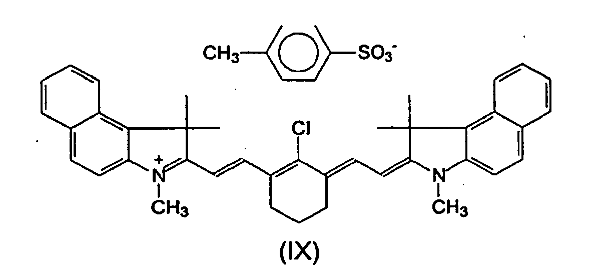

In the same manner, the vinyl polymers having a barbituric acid group in the side chain of Synthesis Examples 4 to 15, and polyurethanes and polyesters of Synthesis Examples 21 to 22, 24, and 25 were used, and coating solutions of Examples 8 to 23 were obtained. The following novolac resin #1 was used in place of the vinyl polymer having a barbituric acid group in the side chain to obtain a coating solution of Comparative Example 2.

A mixture of m-cresol (100 g), p-cresol (66.8 g), phenol (36.0 g), aqueous solution of 37 % by weight formaldehyde (105 g), and oxalic acid (2.5 g) was heated, and was then stirred at 105°C for 3 hours. After water was distilled off by heating to 175°C, the residual monomer was distilled off at 200°C/100 mmHg. The novolac resin #1 obtained by the method described above had a weight-average molecular weight of 4000.

The coating solution was applied on the aluminum support using a bar coater, rod number #14, and was then dried at 120°C for 40 seconds to obtain a positive-working photosensitive planographic printing plate. The coating weight after drying was 2.0 g/m².

This operation was performed on the coating solutions of Examples 7 to 23 and Comparative Example 2 to obtain eighteen kinds of positive-working photosensitive planographic printing plates.

### Image performance

Using a Creo setter 3244 (manufactured by Creo, wavelength: 830 nm, laser power: 8.5 W, revolution speed: 150 rpm) comprising a near infrared semiconductor laser mounted therein, image writing on the positive-working photosensitive planographic printing plates was performed. The photosensitive planographic printing plates of Examples 7 to 19 were developed with a developer prepared by diluting a developer for nega-plate, ND-1 (manufactured by Kodak Polychrome Graphics Co., Ltd.), with water 2 or 3 times, while the photosensitive planographic printing plates of Examples 20-23 and Comparative Example 2 were developed with a developer prepared by diluting a developer for posi-plate, PD-1 (manufactured by Kodak Polychrome Graphics Co., Ltd.), with water 8 times under the conditions shown in Table 6. The dot quality of the planographic printing plate after development was evaluated. The results are shown in Table 6. In the table, "dilution (1/2)" means that 1 part by weight of a stock solution was diluted with water 2 times. Also "dot quality (1-99)" means that the dot quality is good within the entire range from 1 to 99%.

### Press-life

The planographic printing plate used in the evaluation of the image performance was affixed to a printing press, R-700 (manufactured by MAN Roland), and printing was performed using UV ink "Daicure Scepter Black" (manufactured by DAINIPPON INK & CHEMICALS Co., Ltd.) and a solution prepared by diluting the fountain solution "NA-108W" (manufactured by DAINIPPON INK & CHEMICALS Co., Ltd.) 100 times. The press-life was evaluated from the final number of printed pages obtained with accurate printing. The results are shown in Table 6.

### Washing oil resistance

Two samples were cut from the photosensitive planographic printing plate, and dipped in a Daicure washing oil A (A) and a Daicure roller washing oil (B) (both are manufactured by DAINIPPON INK & CHEMICALS Co., Ltd.) used during printing at room temperature for 30 minutes, and then the washing oil resistance was evaluated. The results are shown in Table 6. In the table, the symbol "○" means a rating wherein no change was observed in the streak portion, and the symbol "X" means a rating wherein the streak portion is corroded by the washing oil.

The photosensitive planographic printing plates of Example 7 to 23 and Comparative Example 2 are good in dot quality in the image performance, and reproduction was performed in a range of from 1 to 99%. As is apparent from the results of Examples 7 to 23, the positive-working photosensitive planographic printing plates using the photosensitive composition containing the alkali-soluble resin having a barbituric acid group in the side chain are excellent in washing oil resistance and press-life.

**Table 6**

| | Resin | Developing conditions | | | | Dot quality % | Press-life (number of pages printed) | Washing oil resistance | |
|---|---|---|---|---|---|---|---|---|---|
| | | Developer | Dilution | Temperature (°C) | Time (seconds) | | | A | B |
| Example 7 | Synthesis Example 3 | ND-1 | 1/2 | 25 | 15 | 1-99 | 50,000 | ○ | ○ |
| Example 8 | Synthesis Example 4 | ND-1 | 1/2 | 25 | 15 | 1-99 | 60,000 | ○ | ○ |
| Example 9 | Synthesis Example 5 | ND-1 | 1/2 | 25 | 60 | 1-99 | 50,000 | ○ | ○ |
| Example 10 | Synthesis Example 6 | ND-1 | 1/2 | 25 | 60 | 1-99 | 60,000 | ○ | ○ |
| Example 11 | Synthesis Example 7 | ND-1 | 1/2 | 25 | 50 | 1-99 | 60,000 | ○ | ○ |
| Example 12 | Synthesis Example 8 | ND-1 | 1/3 | 25 | 20 | 1-99 | 60,000 | ○ | ○ |
| Example 13 | Synthesis Example 9 | ND-1 | 1/3 | 25 | 25 | 1-99 | 70,000 | ○ | ○ |
| Example 14 | Synthesis Example 10 | ND-1 | 1/3 | 25 | 40 | 1-99 | 80,000 | ○ | ○ |
| Example 15 | Synthesis Example 11 | ND-1 | 1/2 | 25 | 30 | 1-99 | 70,000 | ○ | ○ |
| Example 16 | Synthesis Example 12 | ND-1 | 1/3 | 25 | 20 | 1-99 | 70,000 | ○ | ○ |
| Example 17 | Synthesis Example 13 | ND-1 | 1/3 | 25 | 20 | 1-99 | 60,000 | ○ | ○ |
| Example 18 | Synthesis Example 14 | ND-1 | 1/3 | 25 | 30 | 1-99 | 60,000 | ○ | ○ |
| Example 19 | Synthesis Example 15 | ND-1 | 1/3 | 25 | 30 | 1-99 | 70,000 | ○ | ○ |
| Example 20 | Synthesis Example 21 | PD-1 | 1/16 | 25 | 30 | 1-99 | 70,000 | ○ | ○ |
| Example 21 | Synthesis Example 22 | PD-1 | 1/16 | 25 | 40 | 1-99 | 80,000 | ○ | ○ |
| Example 22 | Synthesis Example 24 | PD-1 | 1/16 | 25 | 30 | 1-99 | 60,000 | ○ | ○ |
| Example 23 | Synthesis Example 25 | PD-1 | 1/12 | 25 | 30 | 1-99 | 60,000 | ○ | ○ |
| Comparative Example 2 | Novolac resin #1 | PD-1 | 1/8 | 2 | 30 | 1-99 | 5,000 | × | × |

### Negative photosensitive planographic printing plate for an infrared laser

### Examples 24 to 28 and Comparative Example 3

In a 100 ml flask, 60 ml of METHYLCELLOSOLVE® was charged, and after adding the vinyl polymer having a barbituric acid group in the side chain of Synthesis Example 17, the vinyl polymer was completely dissolved by stirring at room temperature for one hour. To the solution, 8.0 g of a GP resin (resol resin, manufactured by Georgia Pacific Corp.), 0.6 g of triazine TCP (manufactured by Honeywell Corp.), 0.6 g of infrared dye 1 (Formula (IX) described above, and 0.08 g of a dye wherein the counter anion of Victoria Pure Blue BOH (manufactured by Hodogaya Chemical Co., Ltd.) is replaced by a 1-naphthalenesulfonic acid anion, were added, followed by stirring at room temperature for 30 minutes. Then, 5 drops of DC190 (surfactant, manufactured by Dow Coming Corporation) were added thereto, followed by stirring at room temperature for 30 minutes. The solution was filtered through a filter having an opening size of 10 µm to obtain a coating solution of Example 24.

In the same manner, the vinyl polymers having a barbituric acid group in the side chain of Synthesis Examples 18 to 19, the polyurethane of Synthesis Example 21, and the polyester of Synthesis Example 25 were used, and coating solutions of Examples 25 to 28 were obtained. The above novolac resin #1 was used in place of the vinyl polymer having a barbituric acid group in the side chain to obtain a coating solution of Comparative Example 3.

The coating solution was applied on the aluminum support using a bar coater, rod number #12, and was then dried at 110°C for 40 seconds to obtain negative-working photosensitive planographic printing plates. The coating weight after drying was 2.0 ± 0.2 g/m².

This operation was performed on the coating solutions of Examples 24 to 28 and Comparative Example 3 to obtain seven kinds of negative-working photosensitive planographic printing plates.

### Image performance

Using a Creo setter 3244 (manufactured by Creo, wavelength: 830 nm, laser power: 8.5 W, revolution speed: 150 rpm) comprising a near infrared semiconductor laser mounted therein, image writing on the negative-working photosensitive planographic printing plates was performed. Subsequently, using a preheating oven, SPC MINI-HD-48/122 (manufactured by Kodak Polychrome Graphics Co., Ltd.), the photosensitive planographic printing plate was subjected to a heat treatment at 129°C (264°F) for 40 seconds. Then, the photosensitive planographic printing plate was developed at 30°C for 20 seconds using a developer prepared by diluting a developer, PD-1 (manufactured by Kodak Polychrome Graphics Co., Ltd.), with water 12 times. The dot quality of the planographic printing plate after the development was evaluated. The results are shown in Table 7. In the table, "dot quality (1-99)" means that the dot quality is good within the entire range from 1 to 99%.

### Press-life

The planographic printing plate used in the evaluation of the image performance was affixed to a printing press, R-700 (manufactured by MAN Roland), and printing was performed using UV ink "GEOS-G Deep Red N" (manufactured by DAINIPPON INK & CHEMICALS Co., Ltd.) and a solution prepared by diluting the fountain solution "NA-108W" (manufactured by DAINIPPON INK & CHEMICALS Co. Ltd.) 100 times and adding 10% by volume of isopropyl alcohol. The press-life was evaluated from the final number of printed pages obtained with accurate printing. The results are shown in Table 7.

### Solvent resistance

Using a Creo setter 3244 (manufactured by Creo, wavelength: 830 nm, laser power 8.5 W, revolution speed: 150 rpm) comprising a near infrared semiconductor laser mounted therein, entire solid image writing on the negative-working photosensitive planographic printing plate was performed. Using a preheating oven, SPC MINI-HD-48/122 (manufactured by Kodak Polychrome Graphics Co., Ltd.), the photosensitive planographic printing plate was subjected to a heat treatment at129°C (264°F) for 40 seconds. Then, the photosensitive planographic printing plate was developed at 30°C for 20 seconds using a developer prepared by diluting a developer, PD-1 (manufactured by Kodak Polychrome Graphics Co., Ltd.), with water 12 times. Two samples were cut from the photosensitive planographic printing plate, and were dipped in a solvent prepared by diluting the fountain solution (NA-108W), used during printing, 100 times, and adding an aqueous solution of 10% by volume of isopropyl alcohol and an aqueous solution of 50% by volume of isopropyl alcohol at room temperature for 30 minutes. The solvent resistance was evaluated. The results are shown in Table 7. In the table, the symbol "○" means a rating wherein no change was observed in the streak portion, the symbol "Δ" means a rating wherein corrosion was observed but the printing plate can be put to use, and the symbol "X" means a rating wherein the streak portion is corroded by the washing oil.

**Table 7**

| | Resin | Dot quality % | Press-life (number of pages printed) | Solvent resistance | |
|---|---|---|---|---|---|
| | | | | Fountain solution | 50% IPA |
| Example 24 | Synthesis Example 17 | 1-99 | 230,000 | ○ | ○ |
| Example 25 | Synthesis Example 18 | 1-99 | 250,000 | ○ | ○ |
| Example 26 | Synthesis Example 19 | 1-99 | 230,000 | ○ | ○ |
| Example 27 | Synthesis Example 21 | 1-99 | 240,000 | ○ | ○ |
| Example 28 | Synthesis Example 25 | 1-99 | 250,000 | ○ | ○ |
| Comparative Example 3 | - | 1-99 | 150,000 | Δ | × |

As is apparent from the results of Examples 25 to 28, the negative-working photosensitive planographic printing plates using the photosensitive composition containing the alkali-soluble resin having a barbituric acid group in the side chain have good image performance and are excellent in washing oil resistance and press-life.

### Novolac resin having a barbituric acid group in the side chain

### Synthesis Example 26

In a 50 ml reaction vessel equipped with a drying tube and a thermometer, 29.8 g of dry N,N-dimethylacetamide and 5.0 g (0.035 mol) of 5-aminobarbituric acid were charged, and 7.8 g (0.035 mol) of isophorone diisocyanate was added dropwise over 10 minutes. Then, 0.05 g of dibutyltin dilaurate as a catalyst was added, and the mixture was continuously stirred at 60°C for 5 days. During stirring, the reaction represented by the following reaction scheme (X) occurred. The progress of the reaction was traced by high performance liquid chromatography, and after confirming that peaks of the unreacted isophorone diisocyanate substantially disappeared, the reaction solution was stored while sealing under a dry nitrogen gas.

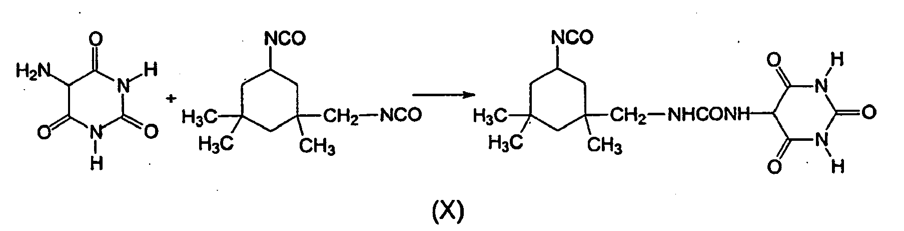

In a 200 ml reaction vessel, 72 ml of dry N,N-dimethylacetamide and 20.0 g of the above novolac resin #1 were charged, and the solution was heated to 80°C while dissolving the novolac resin #1 under a dry nitrogen gas atmosphere. To the solution, 5.1 g of the above reaction solution (30% by weight solution, isocyanate concentration: 0.0042 mol) was added, and 0.05 g of dibutyltin dilaurate as a catalyst was added. The reaction was continued at 80°C until the residual isocyanate disappeared. The concentration of the residual isocyanate was measured by a back titration method by the addition of dibutylamine. After confirming that the residual isocyanate disappeared, the reaction solution was cooled to room temperature, and was then poured into 1 liter of deionized water to deposit a resin. The deposited resin was recovered by filtration, was washed with water, and was then dried under reduced pressure at 40°C to obtain 19.3 g of a novolac resin having a barbituric acid group in the side chain represented by the formula (XI) below. The introduction ratio of the barbituric acid group into the hydroxyl group of the novolac resin was 2.5% by mol (wherein m and n represent the number of repeating units).

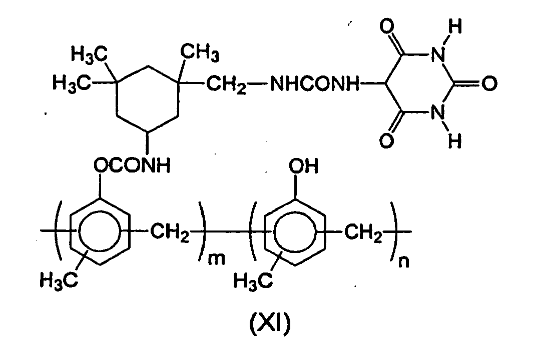

### Synthesis Example 27

In the same manner as described in Synthesis Example 21, except that the amount of the reaction solution (30% by weight solution) to be added to the novolac resin solution was changed to 10.3 g, 20.5 g of a novolac resin having a barbituric acid group in the side chain was obtained. The introduction ratio of the barbituric acid group into the hydroxyl group of the novolac resin was 5.1% by mol.

### Synthesis Example 28

In the same manner as described in Synthesis Example 21, except that the amount of the reaction solution (30% by weight solution) to be added to the novolac resin solution was changed to 19.9 g, 22.9 g of a novolac resin having a barbituric acid group in the side chain was obtained. The introduction ratio of the barbituric acid group into the hydroxyl group of the novolac resin was 9.9% by mol.

### Alkali-soluble acrylic resin

In a 200 ml four-necked flask equipped with a thermometer, a cooling tube, a stirrer, a dropping tube, and a nitrogen gas introducing tube, 46.7 g of N,N-dimethylacetamide was charged. After heating to 85°C, 0.15 g of azobisisobutyronitrile was added under a nitrogen gas atmosphere. Then, a monomer solution prepared by dissolving 15.6 g of N-(4-carboxyphenyl)methacrylamide, 18.5 g of acrylonitrile, 1.5 g of methacrylamide, 1.5 g of N-phenyl maleimide, and 0.45 g of azobisisobutyronitrile in 46.7 g of N,N-dimethylacetamide was added dropwise to N,N-dimethylacetamide in the flask over one hour. After the completion of the dropwise addition, 0.15 g of azobisisobutyronitrile was added to the solution in the flask, and the solution was heated to 100°C. While heating to 100°C, 0.15 g of azobisisobutyronitrile was added every other hour. At the time when the Gardner viscosity of the solution in the flask reached B-C, the addition of azobisisobutyronitrile and heating was terminated, and the solution in the flask was cooled to room temperature. Then, the solution was poured into 1.5 liters of deionized water while stirring to deposit a resin. The deposited resin was recovered by filtration, was washed with water, and was then dried under reduced pressure at 40°C to obtain 34.3 g of an alkali-soluble acrylic resin. The resin had an acid value of 115.

### Two-layered photosensitive planographic printing plate

### Examples 29 to 34 and Comparative Example 4

Positive-working photosensitive planographic printing plates having a two-layered structure for an infrared laser were produced. These photosensitive planographic printing plates have improved developability because the lower layer is composed of an alkali-soluble or alkali-permeable layer, and the upper layer is composed of a layer which is alkali-insoluble or alkali-impermeable, and is made alkali-soluble or alkali-permeable by heat.

A coating solution for the upper layer with the composition shown in Table 8 and a coating solution for the lower layer with the composition shown in Table 9 were prepared. In accordance with the combination shown in Table 10, these coating solutions were slowly applied in sequence on the aluminum support using a roll coater to obtain a positive-working photosensitive planographic printing plate. The respective layers were dried at 100°C for 3 minutes. The coating weight after drying was 0.7 g/m² for the upper layer, and was 1.5 g/m² for the lower layer.

**Table 8**

| Coating solution for upper layer (% by weight) | T1 | T2 | T3 | T4 |
|---|---|---|---|---|
| 1-methoxy-2-propanol | 64.7 | 64.7 | 64.7 | 64.7 |
| Methanol | 27.7 | 27.7 | 27.7 | 27.7 |
| Synthesis Example 26 | 7.1 | | | |
| Synthesis Example 27 | | 7.1 | | |
| Synthesis Example 28 | | | 7.1 | |
| Novolac resin #1 | | | | 7.1 |
| Dye wherein counter ion of Victoria Pure Blue BOH (Hodogaya Chemical Co., Ltd.) is replaced by 1-naphthalenesulfonic acid anion | 0.1 | 0.1 | 0.1 | 0.1 |
| DC190 (surfactant, Dow Corning Corporation) | 0.4 | 0.4 | 0.4 | 0.4 |

**Table 9**

| Coating solution for lower layer (% by weight) | B1 | B2 | B3 | B4 |
|---|---|---|---|---|
| METHYLCELLOSOLVE® | 90.6 | 90.6 | 90.6 | 90.6 |
| Water | 0.9 | 0.9 | 0.9 | 0.9 |
| Alkali-soluble acrylic resin | 5.0 | 5.0 | 5.0 | 5.0 |
| Synthesis Example 26 | 2.0 | | | |
| Synthesis Example 27 | | 2.0 | | |
| Synthesis Example 28 | | | 2.0 | |
| Novolac resin #1 | | | | 2.0 |
| Dye wherein counter ion of Victoria Pure Blue BOH (Hodogaya Chemical Co., Ltd.) is replaced by 1-naphthalenesulfonic acid anion | 0.1 | 0.1 | 0.1 | 0.1 |
| DC190 (surfactant, Dow Coming Corporation) | 0.4 | 0.4 | 0.4 | 0.4 |
| KF654 (PTS) (photothermal conversion material, Yamamoto Chemicals Inc.) | 1.0 | 1.0 | 1.0 | 1.0 |

### Development latitude

Using a Creo setter 3244 (manufactured by Creo, wavelength: 830 nm, laser power: 9 W, revolution speed: 150 rpm) comprising a near infrared semiconductor laser mounted therein, image writing on the positive-working photosensitive planographic printing plates was performed. Then, two kinds of developers were prepared by diluting a developer for posi-plate, PD-1 (manufactured by Kodak Polychrome Graphics Co., Ltd.), with water 6 and 12 times. The image density of 50% dots for the case of developing the photosensitive planographic printing plate at 30°C for 20 seconds using a 6-fold diluted solution and the image density of 50% dots for the case of developing the photosensitive planographic printing plate at 30°C for 20 seconds using a 12-fold diluted solution were measured. Subsequently, a difference between these image densities was determined, and the evaluation was performed using five levels. The results are shown in Table 10. In the table, rating 1 means a large difference between image densities, while rating 5 means substantially no difference between image densities.

### Press-life

Using a Creo setter 3244 (manufactured by Creo, wavelength: 830 nm, laser power: 9 W, revolution speed: 150 rpm) comprising a near infrared semiconductor laser mounted therein, image writing on the positive-working photosensitive planographic printing plate was performed. The photosensitive planographic printing plate was developed at 30°C for 20 seconds using a developer prepared by diluting a developer for posi-plate, PD-1 (manufactured by Kodak Polychrome Graphics Co., Ltd.), with water 9 times to obtain a planographic printing plate. The planographic printing plate was affixed to a printing press R-700 (manufactured by MAN Roland). Printing was performed using UV ink "Daicure Scepter Black" (manufactured by DAINIPPON INK & CHEMICALS Co., Ltd.), and a solution prepared by diluting the fountain solution "NA-108W" (manufactured by DAINIPPON INK & CHEMICALS Co., Ltd.) 100 times. The press-life was evaluated from the final number of printed pages obtained with accurate printing. The results are shown in Table 10.

### Washing oil resistance

Two samples were cut from the planographic printing plate, and were dipped in a Daicure washing oil A (A in the table) and a Daicure roller washing oil (B in the table) (both are manufactured by DAINIPPON INK & CHEMICALS Co., Ltd.) used during printing, at room temperature for 30 minutes. Subsequently, the washing oil resistance was evaluated using five levels. The results are shown in Table 10. In the table, "5" means a rating wherein no change was observed in the streak portion, while the corrosion degree of the streak portion due to the washing oil increased as the number approaches "1".

**Table 10**

| | Coating solution | | Development latitude 1 (poor) - 5 (excellent) | Press-life (number of pages printed) | Washing oil resistance |
|---|---|---|---|---|---|
| | Upper layer | Lower layer | | | |
| Example 29 | T1 | B4 | 2 | 80,000 | 4 |
| Example 30 | T2 | B4 | 3 | 85,000 | 4 |
| Example 31 | T3 | B4 | 2 | 90,000 | 4 |
| Example 32 | T2 | B1 | 4 | 100,000 or more | 5 |
| Example 33 | T2 | B2 | 5 | 100,000 or more | 5 |
| Example 34 | T2 | B3 | 5 | 100,000 or more | 5 |
| Comparative Example 4 | T4 | B4 | 1 | 70,000 | 3 |

As is apparent from the results of Examples 29 to 34, two-layered structure positive-working photosensitive planographic printing plates using the photosensitive composition containing the alkali-soluble resin having a barbituric acid group in the side chain are excellent in development latitude, washing oil resistance, and press-life.

### Effects of the Invention

As described above, the photosensitive composition of the present invention is a photosensitive composition containing a resin having a barbituric acid group in the side chain, and for this reason, a coating film exhibiting superior solvent resistance and superior wear resistance can be obtained.

In addition, the photosensitive planographic printing plate of the present invention exhibits superior solvent resistance, particularly resistance to UV ink-washing oil used in UV ink printing, and superior press-life when a photosensitive layer made of the photosensitive composition is provided on the surface of a support.

## Claims

1. A photosensitive composition comprising a resin having an alkali-soluble barbituric acid group in a side chain;
in which
the resin having the alkali-soluble barbituric acid group in the side chain is selected from the group consisting of vinyl polymers, novolac resins, polyurethanes, polyesters, and polyureas; and
the composition additionally comprises:
(a) an o-quinone diazide compound; or
(b) a photosensitive diazonium compound; or
(c) an ethylenically unsaturated compound and a radical polymerization initiator; or
(d) a photothermal conversion material; or
(e) a compound that generates an acid by heat, an acid crosslinking agent, and a photothermal conversion material.

2. The photosensitive composition of claim 1 in which the composition is a positive-working composition that comprises the o-quinone diazide compound.

3. The photosensitive composition of claim 1 in which the composition is a negative-working composition that comprises the photosensitive diazonium compound.

4. The photosensitive composition of claim 1 in which the composition is a negative-working composition that comprises the ethylenically unsaturated compound and the radical polymerization initiator.

5. The photosensitive composition of claim 1 in which the composition is a positive working composition that comprises a photothermal conversion material.

6. The photosensitive composition of claim 1 in which the composition is a negative-working composition that comprises the compound that generates an acid by heat, the acid crosslinking agent, and the photothermal conversion material.

7. The photosensitive composition of any one of claims 1 to 6 in which the barbituric acid group is represented by the general formula (I): 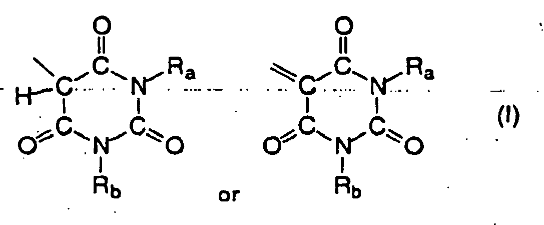 in which Rₐ and R_{b} are each independently a hydrogen atom, an alkyl group that may have a substituent, or a phenyl group that may have a substituent.

8. The photosensitive composition of claim 7 in which Rₐ and R_{b} are each a hydrogen atom.

9. A photosensitive planographic printing plate precursor comprising a support and a photosensitive layer comprising the photosensitive composition of any one of claims 1 to 8 on a surface of the support.

10. A method for forming a planographic printing plate, the method comprising the steps of:
imaging the planographic printing plate precursor of claim 9, and
developing the imaged planographic printing plate precursor with a developer

## Patentansprüche

1. Lichtempfindliche Zusammensetzung, umfassend ein Harz mit einer alkalilöslichen Barbitursäuregruppe in einer Seitenkette;
wobei das Harz mit der alkalilöslichen Barbitursäuregruppe in der Seitenkette aus Vinylpolymeren, Novolakharzen, Polyurethanen, Polyestern und Polyharnstoffen ausgewählt ist; und
die Zusammensetzung zusätzlich umfasst:
(a) eine o-Chinondiazid-Verbindung oder
(b) eine lichtempfindliche Diazoniumverbindung oder
(c) eine ethylenisch ungesättigte Verbindung und einen Initiator für radikalische Polymerisation oder
(d) ein photothermisches Umwandlungsmaterial oder
(e) eine Verbindung, die bei Wärme eine Säure erzeugt, ein durch Säure vernetzendes Mittel, und ein photothermisches Umwandlungsmaterial.

2. Lichtempfindliche Zusammensetzung gemäß Anspruch 1, wobei die Zusammensetzung eine positiv arbeitende Zusammensetzung ist, die die o-Chinondiazid-Verbindung umfasst.

3. Lichtempfindliche Zusammensetzung gemäß Anspruch 1, wobei die Zusammensetzung eine negativ arbeitende Zusammensetzung ist, die die lichtempfindliche Diazoniumverbindung umfasst.

4. Lichtempfindliche Zusammensetzung gemäß Anspruch 1, wobei die Zusammensetzung eine negativ arbeitende Zusammensetzung ist, die die ethylenisch ungesättigte Verbindung und den Initiator für radikalische Polymerisation umfasst.

5. Lichtempfindliche Zusammensetzung gemäß Anspruch 1, wobei die Zusammensetzung eine positiv arbeitende Zusammensetzung ist, die ein photothermisches Umwandlungsmaterial umfasst.

6. Lichtempfindliche Zusammensetzung gemäß Anspruch 1, wobei die Zusammensetzung eine negativ arbeitende Zusammensetzung ist, die die Verbindung, die bei Wärme eine Säure erzeugt, das durch Säure vernetzende Mittel und das photothermische Umwandlungsmaterial umfasst.

7. Lichtempfindliche Zusammensetzung gemäß einem der Ansprüche 1 bis 6, wobei die Barbitursäuregruppe durch die allgemeine Formel (I) dargestellt wird: 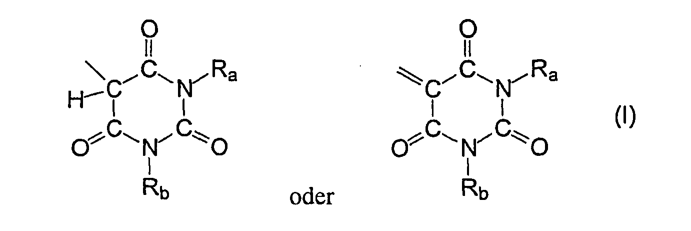 wobei Rₐ und R_{b} jeweils unabhängig ein Wasserstoffatom, ein Alkylrest, der einen Substituenten haben kann, oder ein Phenylrest, der einen Substituenten haben kann, sind.

8. Lichtempfindliche Zusammensetzung gemäß Anspruch 7, wobei Rₐ und R_{b} jeweils ein Wasserstoffatom sind.

9. Lichtempfindlicher Flachdruckplattenvorläufer, umfassend einen Träger und eine lichtempfindliche Schicht, umfassend die lichtempfindliche Zusammensetzung gemäß einem der Ansprüche 1 bis 8 auf einer Oberfläche des Trägers.

10. Verfahren zur Erzeugung einer Flachdruckplatte, wobei das Verfahren die Schritte umfasst:
Bebildern des Flachdruckplattenvorläufers gemäß Anspruch 9, und Entwickeln des bebilderten Flachdruckplattenvorläufers mit einem Entwickler.

## Revendications

1. Composition photosensible comprenant une résine ayant un groupe acide barbiturique soluble dans les alcalis dans une chaîne latérale ;
dans laquelle
la résine ayant le groupe acide barbiturique soluble dans les alcalis dans la chaîne latérale est choisie dans le groupe comprenant des polymères vinyliques, des résines novolaques, des polyuréthanes, des polyesters et des polyurées ; et
la composition comprend aussi :
a) un composé d'o-quinone diazide ; ou
b) un composé de diazonium photosensible ; ou
c) un composé ayant une insaturation de type éthylénique et un initiateur de polymérisation radicalaire ; ou
d) un matériau de conversion photothermique, ou
e) un composé qui génère un acide à l'aide de la chaleur, un agent de réticulation acide et un matériau de conversion photothermique.

2. Composition photosensible selon la revendication 1, dans laquelle la composition est une composition positive qui comprend le composé o-quinone diazide.

3. Composition photosensible selon la revendication 1, dans laquelle la composition est une composition négative qui comprend le composé de diazonium photosensible.

4. Composition photosensible selon la revendication 1, dans laquelle la composition est une composition négative qui comprend le composé ayant une insaturation de type éthylénique et l'initiateur de polymérisation radicalaire.

5. Composition photosensible selon la revendication 1, dans laquelle la composition est une composition positive qui comprend un matériau de conversion photothermique.

6. Composition photosensible selon la revendication 1, dans laquelle la composition est une composition négative qui comprend le composé qui génère un acide à l'aide de la chaleur, l'agent de réticulation acide et le matériau de conversion photothermique.

7. Composition photosensible selon l'une quelconque des revendications 1 à 6, dans laquelle le groupe acide barbiturique est représenté par la formule générale (I) : 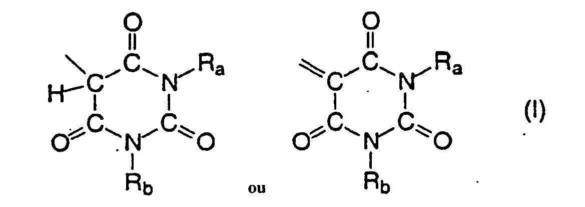 dans laquelle Rₐ et R_{b} représentent chacun séparément un atome d'hydrogène, un groupe alkyle qui peut avoir un substituant, ou un groupe phényle qui peut avoir un substituant.

8. Composition photosensible selon la revendication 7, dans laquelle Rₐ et R_{b} représentent chacun un atome d'hydrogène.

9. Précurseur de plaque d'impression planographique photosensible comprenant un support et une couche photosensible comprenant la composition photosensible de l'une quelconque des revendications 1 à 8 sur une surface du support.

10. Procédé de formation d'une plaque d'impression planographique, comprenant les étapes de :
formation d'image du précurseur de plaque d'impression planographique selon la revendication 9, et
développement du précurseur exposé de plaque d'impression planographique avec un révélateur.
